(19) Europäisches Patentamt
European Patent Office
Office européen des brevets

(11) EP 1 435 369 B1

(12) EUROPEAN PATENT SPECIFICATION

(45) Date of publication and mention of the grant of the patent:
**07.02.2007 Bulletin 2007/06**

(51) Int Cl.:
***C08J 5/22*** *(2006.01)*

(21) Application number: **03257179.6**

(22) Date of filing: **13.11.2003**

# (54) composition for preparing porous dielectric films

Zusamensetzung zur Herstellung von porösen dielektrischen Filmen

composition pour la préparation de films diélectriques poreux.

(84) Designated Contracting States:
**DE FI FR GB SE**

(30) Priority: **03.12.2002 KR 2002076275**

(43) Date of publication of application:
**07.07.2004 Bulletin 2004/28**

(73) Proprietor: **SAMSUNG ELECTRONICS CO., LTD.**
**Suwon-Shi, Gyeonggi-Do 442-742 (KR)**

(72) Inventors:
- **Lyu, Yi Yeol**
**Suji-Eup,**
**Yongin-Si,**
**Gyeonggi-Do (KR)**
- **Kim, Ji Man**
**Paldal-Gu,Suwong-Shi,Gyeonggi-Do 442-739 (KR)**
- **Lee, Kwang Hee**
**Paldal-Gu,Suwong-Shi,Gyeonggi-Do 442-724 (KR)**
- **Chang, Seok**
**Yuseong-Gu, Daejeon-Shi 305-728 (KR)**
- **Yim, Jin Heong**
**Yeongtong-Gu,**
**Suwon-Si (KR)**
- **Park, Jae Geun**
**Yuseong-Gu, Daejeon-Shi 305-728 (KR)**

(74) Representative: **Kyle, Diana**
**Elkington and Fife LLP,**
**Prospect House**
**8 Pembroke Road**
**Sevenoaks,**
**Kent TN13 1XR (GB)**

(56) References cited:
**EP-A- 0 672 702** **US-B1- 6 270 846**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 435 369 B1

## Description

The present invention relates to a composition for preparing porous dielectric thin film containing novel pore-generating material. More specifically, the present invention relates to a composition comprising siloxane-based gemini detergent or mixtures thereof with fourth alkyl ammonium as a pore-generating material, so as to form porous interlayer dielectric thin film with good mechanical property and hydroscopic resistance.

Substances having nano-pores have been known to be useful for absorbents, carriers for catalysts, thermal insulators and electric insulators in various fields. In particular, they have been recently reported useful as materials for insulating films between interconnect layers in semiconductor devices. As the integration level has been increased in semiconductor devices, the performance of the devices is determined by the speed of wires. Accordingly, the storage capacity of interconnect thin film is required to be lowered to decrease the resistance and capacity in wires. For this purpose, there have been attempts to use materials with low dielectric constant in the insulating film. For example, US Patent Nos. 3,615,272, 4,399,266 and 4,999,397 disclose polysilsesquioxanes with a dielectric constant of 2.5-3.1 which can be used in Spin On Deposition(SOD), as an alternative for $SiO_2$ with a dielectric constant of 4.0 which has been used in Chemical Vapor Deposition(CVD). In addition, US Patent No. 5,965,679 describes organic high molecules with a dielectric constant of 2.65-2.70, polyphenylenes. However, the dielectric constants of the previous matrix materials are not sufficiently low to achieve a very low dielectric constant less than 2.50 required for high-speed devices.

To solve this problem, there have been various trials to incorporate air bubbles into these organic and inorganic matrixes at a nano-scale. In this connection, US Patent No. 6,231,989 B1 describes a use of lactone-based denriric polymer as a porogen, which may be decomposed by heating. Further, US Patent Nos. 6,107,357 and 6,093,636 disclose a method for preparing very low dielectric constant (k<3.0) substances comprising the steps of mixing a the vinyl-based high molecular dendrimer pore-generating material such as polystyrene, polymethacrylate and polyester which are degradable in the heating step to form a thin film; making a thin film by mixing these and the like along with the organic or inorganic matrix; and decomposing the pore-generating materials contained in the mixture at a high temperature to form nano-pores.

US-B1-6,270,846 relates to a method for making surfactant-templated, high porosity thin films using a precursor sol, a solvent, water, a surfactant and a hydrophobic polymer wherein the surfactant can be a cationic surfactant such as gemini surfactant and dialkyldimethylammonium.

Preparing the materials having pores with gemini detergent and fourth alkylammonium as pore-generating material, we completed this invention by discovering the material that has sufficiently low dielectric constant and satisfactory physical property of matter in physical property and hygroscopic resistance.

In accordance with one aspect of the present invention, there is provided a composition for preparing porous dielectric thin film, said composition comprising:

(1) a pore generating material of gemini detergent represented by the formula (8), or a mixture thereof with a quaternary alkylammonium salt represented by the formula (9); (2) thermo-stable organic or inorganic matrix precursor; and (3) a solvent for dissolving both the said material and the matrix precursor.

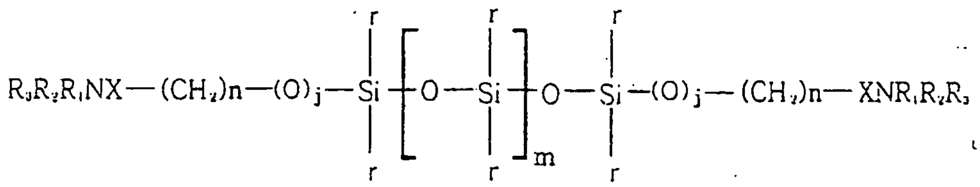

(8)

In the above formula (8),
$R_1$ and $R_2$ are independently methyl group or ethyl group,
$R_3$ is $C_{5-40}$ alkyl group,
X is halogen atom,
R is independently hydrogen atom, methyl group or $C_{1-10}$ alkoxy group,
j is 0 or 1,
n is an integer ranging from 1 to 12,
m is an integer ranging from 0 to 10.

$$NL_1L_2L_3\,L_4X \qquad (9)$$

In the above formula (9),
N is nitrogen atom,
X is halogen atom,
$L_1$, $L_2$, $L_3$, and $L_4$ are independently $C_{1-30}$ alkyl group.

In another aspect of the present invention, there is provided a method for forming interlayer insulating film between interconnect layers in semiconductor devices, said method comprising spreading onto a substrate with said composition on said substrate; evaporating the solvent from said substrate and heating said substrate at 150~600°C under inert gas atmosphere or vacuum condition.

Still another aspect of the present invention is a material with pores produced by said composition.

Another aspect of the present invention, there is provided the use of substances having pores as heat resisting materials, electric insulators, absorbents, carriers for catalysts, and so on.

Hereinafter, the present invention will be explained in more detail in the following Examples with reference to the accompanying drawings.

The thermo-stable matrix precursors used in the composition of the present invention may be organic or inorganic high molecules having a glass transition temperature higher than 400°C.

Examples of the inorganic high molecule include, without limitation, (1) silsesquioxane, (2) alkoxy silane sol with a number average molecular weight of 500-20,000, derived from partial condensation of at least silane monomer such as $SiOR_4$, $RSiOR_3$ or $R_2SiOR_2$(R is organic substituent), <etc>, (3) a polysiloxane with a number average molecular weight of 1000-1,000,000, derived from partial condensation of at least one kind of cyclic or cage structure-siloxane monomer such as $SiOR_4$, $RSiOR_3$ or $R_2SiOR_2$(R is organic substituent).

Particularly, the silsesquioxane can be exemplified by hydrogen silsesquioxane, alkyl silsesquioxane, aryl silsesquioxane, and copolymer of these silsesquioxanes.

In addition, organic high molecules, which cure into stable reticular structure at a high temperature, are also preferred as the matrix precursor. Non-limiting examples of the organic high molecule include polyimide-based polymers, which can undergo imidization, such as poly (amic acid), and poly (amic acid ester); polybenzocyclobutene-based polymers; and polyarylene-based polymers such as polyphenylene, and poly (arylene ether).

In the present invention, the further preferred matrix precursor is an organic polysiloxane, which has good solubility and at least 10mol%, preferably 25mol% or more Si-OH content. The organic polysiloxane is prepared through hydrolysis and polycondensation of siloxane monomers having cyclic or cage structure selectively mixed with more a silane monomer such as $SiOR_4$, $RSiOR_3$ or $R_2SiOR_2$ in a solvent in the present of acidic catalyst and water in the presence of a solvent. When a silane monomer is mixed, the ratio of siloxane monomers having either cyclic or cage structure to silnae monomer is 0.99:0.01 - 0.01:0.99, preferably 0.8:0.2 - 0.1:0.9, more preferably 0.6:0.4 - 0.2:0.8.

The siloxane monomer having cyclic structure can be represented by the formula (1).

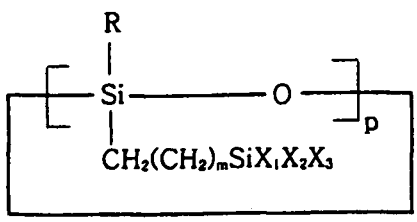

(1)

In the above formula (1),
R is hydrogen atom, $C_{1-3}$ alkyl group, $C_{3-10}$ cycloalkyl group, or $C_{6-15}$ aryl group;
$X_1$, $X_2$ and $X_3$ are independently $C_{1-3}$ alkyl group, $C_{1-10}$ alkoxy group, or halogen atom; and at least one of them is hydrolysable;
p is an integer ranging from 3 to 8; and
m is an integer ranging from 0 to 10.

As can be seen from the above formula (1), silicon atoms are linked to each other through oxygen atoms to form cyclic structure, and the end of each branch comprises organic groups constituting a hydrolyzable substituent.

The method for preparing the cyclic siloxane monomers is not specifically limited, but hydrosililation reaction using a metal catalyst is preferred.

The siloxane monomer having cage structure can be represented by the following formulae (2) to (4).

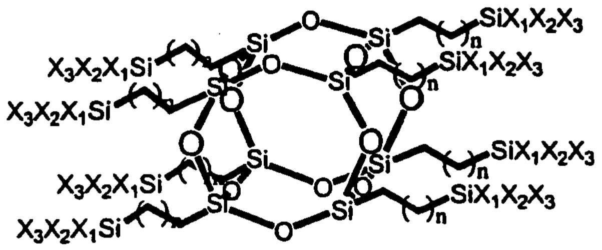

(2)

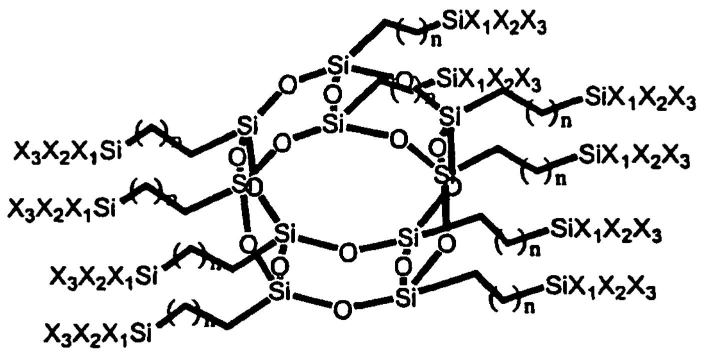

(3)

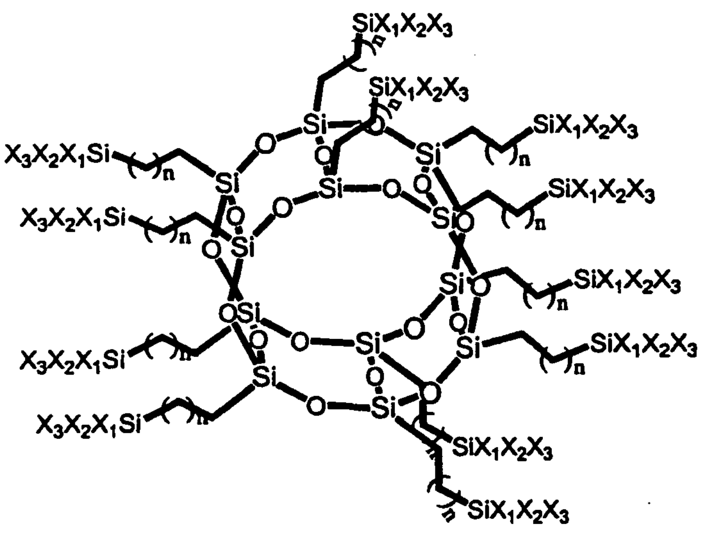

(4)

In the above formulae (2) to (4),
$X_1$, $X_2$ and $X_3$ are independently hydrogen atom, $C_{1-3}$ alkyl group, $C_{1-10}$ alkoxy group, or halogen atom, and at least one of them is hydrolyzable and;
n is an integer ranging from 1 to 10.

The method of preparing siloxane monomers having cage structure is not specially limited, but prepared by hydrosililation using metallic catalyst as previously known methods in the art.

The silane-based monomers can be represented by the following formulae (5) - (7).

$SiX_1X_2X_3X_4$ (5)

$RSiX_1X_2X_3$ (6)

$R_1R_2\,Si\,X_1X_2$ (7)

In the above formulae (5) to (7),
R is hydrogen atom, $C_{1-3}$ alkyl group, $C_{3-10}$ cycloalkyl group, or $C_{6-15}$ aryl group; and
$X_1$, $X_2$ $X_3$ and $X_4$ are independently $C_{1-10}$ alkoxy group, or halogen atom.

The catalyst used in the condensation reaction for preparing matrix precursor is not specifically limited, but preferably hydrochloric acid, benzenesulfonic acid, oxalic acid, formic acid, or a mixture.

In the hydrolysis and polycondensation reaction, water is added at 1.0-100.0 equivalents, preferably 1.0~10.0 equivalents per one equivalent of reactive groups in the monomers, and then the reaction is carried out at 0~200°C, preferably 50~110°C, for 1~100hrs, preferably 5~24hrs.

The organic solvent used in this reaction is preferably aromatic hydrocarbon solvent such as toluene, xylene, and mesitylene; ketone-based solvent such as methyl isobutyl ketone, and acetone; ether-based solvent such as tetrahydrofuran, and isopropyl ether; acetate-based solvent such as propylene glycol monomethyl ether acetate; amide-based solvent such as dimethylacetamide, and dimethylformamide; γ-butyrolactone; silicon solvent or a mixture thereof. The thermo-unstable pore-generating materials used in the present invention are gemini detergent represented by the formula (8) or a mixture thereof with a quaternary alkylammonium salt represented by the formula (9);

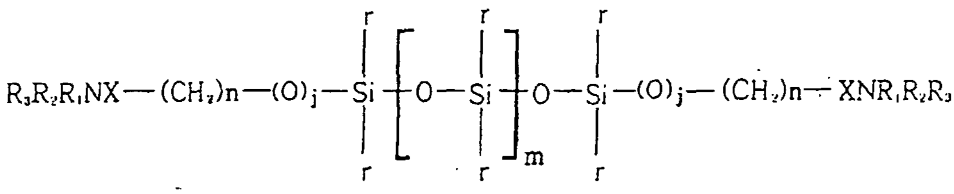

(8)

In the above formula (8),
$R_1$ and $R_2$ are independently methyl group or ethyl group;
R3 is $C_{5-40}$ alkyl group;
X is halogen atom;
r is independently hydrogen atom, methyl group or $C_{1-10}$ alkoxy group;
j is 0 or 1;
n is an integer ranging from 1 to 12; and
m is an integer ranging from 0 to 10.

$NL_1L_2L_3\,L_4X$ **(9)**

In the above formula (9),
N is nitrogen atom;
X is halogen atom; and
$L_1$, $L_2$, $L_3$, and $L_4$ are independently $C_{1-30}$ alkyl group.

The gemini detergent in the above is prepared by the reaction of the materials represented by the formula(10) and the formula (11) in a solvent such as ethanol, acetonitrile, toluene, etc. at the temperature of 30°C ~120°C, preferably 60°C~ 90°C for 1~100hr, preferably for 24-72.

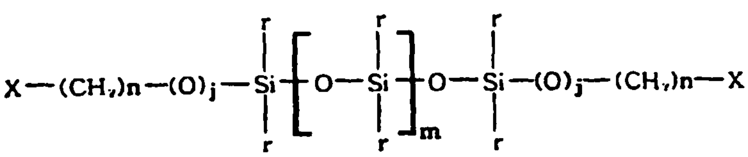

**(10)**

In the above formula (10),
X is halogen atom;
r is independently hydrogen atom, methyl group or $C_{1-10}$ alkoxy group,

j is 0 or 1;
n is an integer ranging from 1 to 12; and
m is an integer ranging from 0 to 10

$$R_3 R_2 R_1 N \qquad (11)$$

In the above formula (11),
$R_1$ and $R_2$ are independently methyl group or ethyl group; and
$R_3$ is $C_{5-40}$ alkyl group.
In this reaction, the mole ratio of the material represented by the following formula (10) to the following formula f (11) is 1:2 ~ 1:3.

The fourth alkylammonate can be obtained commercially, and the particular examples include, but not limited to, tetramethylammonium bromide, tetraethylammonium bromide, tetrapropylammonium bromide, tetrabutylammonium bromide, tetrapentylammonium bromide, tetrahexylammonium bromide, tetraheptylammonium bromide, tetraoctylammonium bromide, tetrahexadecylammonium bromide, tetraoctadecylammonium bromide, diethyldimethylammonium bromide, dipropyldimethylammonium bromide, dibutyldimethylammonium bromide, dipentyldimethylammonium bromide, dihexyldimethylammonium bromide, diheptyldimethylammonium bromide, dioctyldimethylammonium bromide, and didecyldimethylammonium bromide.

In the composition of the present invention, a cyclodextrin-based derivatives represented by the following formula (12) may be further added as a porogen in order to improve the dielectric constant and to elevate hygroscopicity in addition to the gemini detergent, fourth alkylammonate, or a mixture thereof.

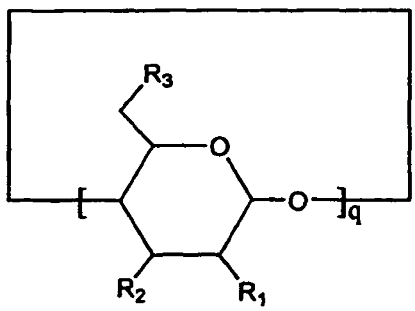

(12)

In the above formula (12),
q is an integer ranging from 6 to 12;
$R_1$, $R_2$ and $R_3$ are independently halogen atom, $C_{0-10}$ amino group or azido group, $C_{3-20}$ imidazole group or pyridino group, $C_{1-10}$ cyano group, $C_{2-10}$ carbonate group, $C_{3-10}$ carbamate group, or $-OR_4$, wherein $R_4$ is hydrogen atom, $C_{2-30}$ acyl group, $C_{1-20}$ alkyl group, $C_{3-10}$ alkene group, $C_{3-20}$ alkyne group, $C_{7-20}$ tosyl group, $C_{1-10}$ mesyl group, $C_{0-10}$ phosphorous group, $C_{3-10}$ cycloalkyl group, $C_{6-30}$ aryl group, $C_{1-20}$ hydroxy alkyl group, or carboxyl group, $C_{1-20}$ carboxy alkyl group, glucosyl group or maltosyl group, or a silicon compound represented by $Sir_1r_2r_3$, wherein $r_1$, $r_2$ and $r_3$ are independently $C_{1-5}$ alkyl group, $C_{1-5}$ alkoxy group, or $C_{6-20}$ aryl group.

Examples of the pore-generating material used in the present invention include α-, β- and γ- cyclodextrins represented by the following formulas (13) to (15), all of which have limited 3D structure with maximum radius of about 13~17Å.

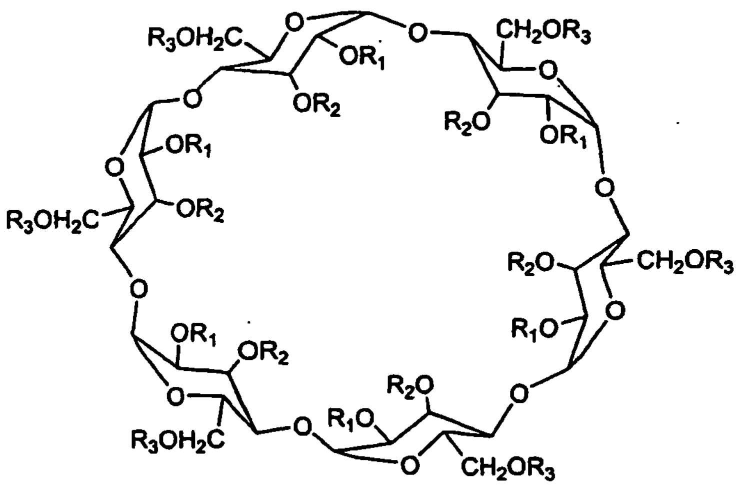

(13)

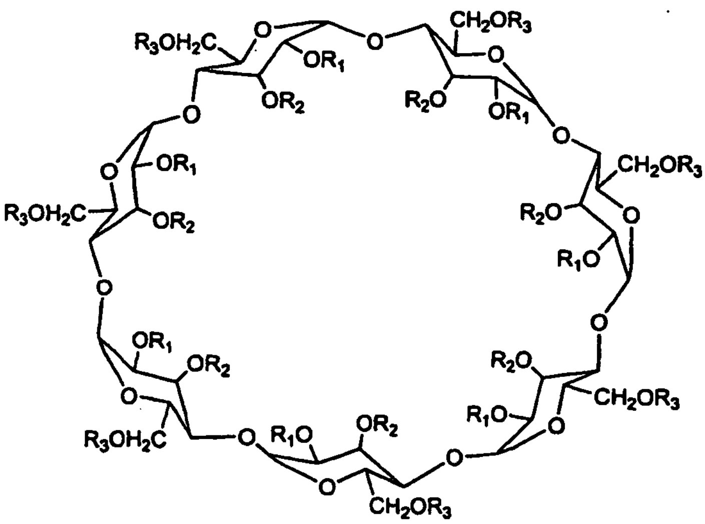

(14)

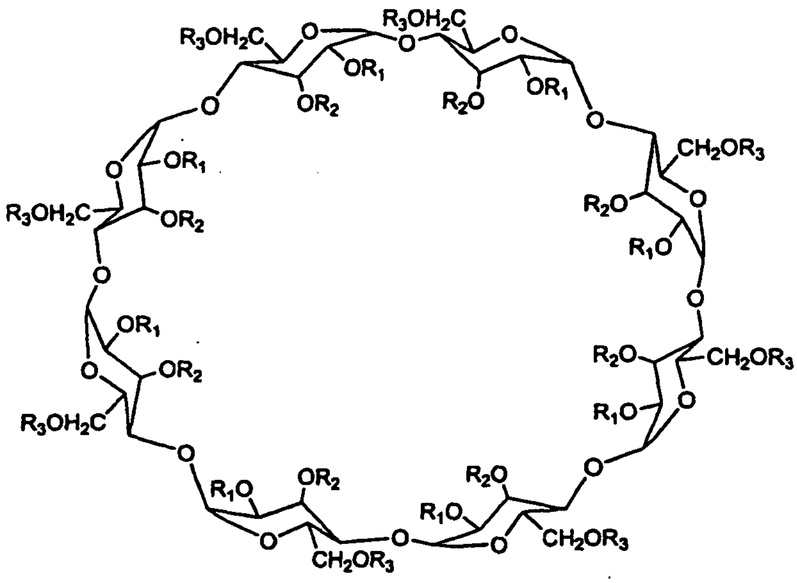

(15)

In the above formulae (13) to (15);
$R_1$, $R_2$ and $R_3$ are the same as those determined in the formula (12).

In the above α-, β- and γ- cyclodextrin derivatives, $R_1$, $R_2$ and $R_3$ are preferably $C_{2-30}$ acyl group, $C_{1-20}$ alkyl group, $C_{3-10}$ alkene group, $C_{3-20}$ alkyne group, $C_{3-10}$ cycloalkyl group, $C_{6-30}$ aryl group, or a silicon compound represented by $Sir_1r_2r_3$, wherein $r_1$, $r_2$ and $r_3$ are independently $C_{1-5}$ alkyl group, $C_{1-5}$ alkoxy group, or $C_{6-20}$ aryl group.

Specific examples of the cyclodextrin derivatives include, but not limited to, hexakis (2,3,6-tri-O-acetyl)-α-cyclodextrin, heptakis (2,3,6-tri-O-acetyl)-β-cyclodextrin, octakis (2,3,6-tri-O-acetyl)-γ-cyclodextrin, heptakis (2,3,6-tri-o-propanoyl)-β-cyclodextrin, heptakis (2,3,6-tri-O-butanoyl)-β-cyclodextrin, heptakis (2,3,6-triO-pentanoyl)-β-cyclodextrin, hexakis (2,3,6-tri-O-benzoyl)-α-cyclodextrin, heptakis (2,3,6-tri-O-benzoyl)-β-cyclodextrin, octakis (2,3,6-tri-O-benzoyl)-γ-cyclodextrin, hexakis(2,3,6-tri-O-methyl)-α-cyclodextrin, heptakis(2,3,6-tri-O-methyl)-β-cyclodextrin, hexakis(6-O-tosyl)-α-cyclodextrin, hexakis(6-amino-6-O-deoxy)-α-cyclodextrin, heptakis(6-amino-6-deoxy)-β-cyclodextrin, bis(6-azido-6-deoxy)-β-cyclodextrin, hexakis(2,3-O-acetyl-6-bromo-6-deoxy)-α-cyclodextrin, heptakis(2,3-O-acetyl-6-bromo-6-deoxy)-β-cyclodextrin, mono(2-O-phosphoryl)-α-cyclodextrin, mono(2-O-phosphoryl)-β-cyclodextrin, hexakis(6-deoxy-6-(1-imdazolyl))-β-cyclodextrin, and mono(2,(3)-O-carboxymethyl)-α-cyclodextrin, heptakis(2,3,6-tri-O-trimethylsilyl)-β-cyclodextrin, and heptakis (2,3,6-tri-O-dimethylsilyl)-β-cyclodextrin.

The content of the cyclodextrin derivative is preferably 5.0~95 wt.%, more preferably 20~80 wt.% of the whole pore-generating material.

In the present invention, the composition for producing substances having pores may be prepared by dissolving the above mentioned thermo-stable matrix precursor and the thermo-unstable pore-generating material in an appropriate solvent.

Examples of this solvent include, but not limited to, aromatic hydrocarbons such as anisole, mesitylene and xylene; ketones such as methyl isobutyl ketone and acetone; ethers such as tetrahydrofuran and isopropyl ether; acetates such as propylene glycol methyl ether acetate; amides such as dimethylacetamide and dimethylformamide; γ-butyolactone; silicon solvents; and a mixture thereof.

The solvent should be used in sufficient amount to coat a substrate fully with the two solid components (matrix precursor + cyclodextrin derivative), and may be present in the range of 20~99.9 wt.%, preferably 50~95wt.%, in the composition (matrix precursor + pore-generating material + solvent). There is a problem that a thin film is not formed uniformly if the solvent is used less than 20 wt.% because of high viscosity, to the contrary, the thickness is too thin if the solvent is used more than 99.9wt. %.

Further, content of the pore-generating material is preferably 0.1~95 wt.%, more preferably 10~70 wt.% of the solid components (matrix precursor + pore-generating material). There is a problem that the mechanical properties of the film are deteriorated if the pore-generating material is used more than 95 wt.%. To the contrary, the dielectric constant of the film is not lowered due to poor formation of pores if pore-generating material is used less than 10wt.%.

According to the present invention, the thin film having pores formed on a substrate by the use of the composition of the present invention serves as a good interlayer insulating film required for semiconductor devices. The composition of the present invention is first coated onto a substrate through spin-coating, dip-coating, spray-coating, flow-coating,

screen-printing and so on. More preferably, the coating step is carried out by spin-coating at 1000-5000 rpm. Following the coating, the solvent is evaporated from the substrate for a resinous film to deposit on the substrate. At this time, the evaporation may be carried out by simple air-drying, or by subjecting the substrate, at the beginning of curing step, to vacuum condition or mild heating(≤100°C).

The resulting resinous coating film may be cured by heating at a temperature of 150~600°C, more preferably 200~450°C wherein pyrolysis of the pore-generating material occurs, so as to provide insoluble film without crack. As used herein, by "film without crack" is meant a film without any crack observed with an optical microscope at a magnification of 1000X. As used herein, by "insoluble film" is meant a film, which is substantially insoluble in any solvent described as being useful for the coating and deposition of the siloxane-based resin. The heat-curing of the coating film may be performed under inert gas atmosphere or vacuum condition for even 10hrs, preferably 30min to 1hrs. After curing process, pore-generating materials are decomposed to generate pores.

The thin film obtained from the above has a low dielectric constant (k≤2.5). Further, in the case that about 30 weight parts of the cyclodextrin-based pore-generating material are mixed with 70 weight parts of the matrix precursor (i.e., content of the porogen is 30wt.% of the solid mixture), very low dielectric constant (k≤2.2) may be also achieved.

The material with pores generated by the above compositions can be further applied in the various field, particularly used as absorbents, carriers for catalysts, thermal insulators and electric insulators, low dielectric materials.

Hereinafter, the present invention will be described in more detail with reference to the following Examples. However, these Examples are given for the purpose of illustration and are not to be construed as limiting the scope of the invention.

**Example 1 - Synthesis of matrix monomers**

**Example 1-1: Synthesis of matrix monomer A**

To a flask were added 29.014mmol(10.0g) of 2,4,6,8-tetramethyl-2,4,6,8-tetravinylcyclotetrasiloxane and 0.164g of platinum (O)-1,3-divinyl-1,1,3,3-tetramethyldisiloxane complex(solution in xylene), and then diluted with 300ml of diethylether. Next, the flask was cooled to -78°C, 127.66mmol(17.29g) trichlorosilane was slowly added thereto, and then it was slowly warmed to room temperature. The reaction was continued at room temperature for 20hrs, and any volatile materials were removed from the reaction mixture under reduced pressure of about 0.1torr. To the mixture was added 100ml pentane and stirred for 1hr, and then the mixture was filtered through celite to provide a clear colorless solution. The pentane was evaporated from the solution under reduced pressure of about 0.1 torr to afford a colorless liquid compound, $[-Si(CH_3)(CH_2CH_2Cl_3)O-]_4$ in a yield of 95%.

11.28mmol(10.0g) of the compound was diluted with 500ml of tetrahydrofuran, and 136.71mmol(13.83g) of triethylamine was added thereto. Thereafter, the mixture was cooled to -78°C, 136.71mmol(4.38g) of methyl alcohol was slowly added thereto, and it was slowly warmed again to room temperature. The reaction was continued at room temperature for 15hrs, filtered through celite, and then volatile materials were evaporated from the filtrate under reduced pressure of about 0.1torr. Subsequently, 100ml of pentane was added thereto and stirred for 1hr, and then the mixture was filtered through celite to provide a clear colorless solution. The pentane was evaporated from this solution under reduced pressure of about 0.1torr to afford monomer A represented by the following formula (11) as a colorless liquid in a yield of 94%:

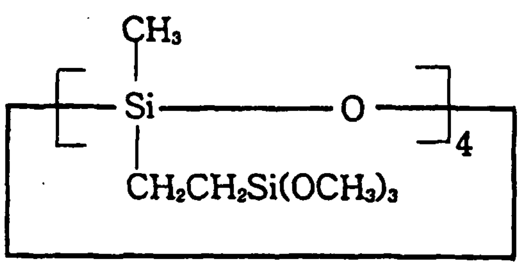

(11)

**Example 2 - Synthesis of matrix precursors**

**Example 2-1**

**Precursor A: Homopolymerization of monomer A**

To a flask was added 9.85mmol(8.218g) of monomer A, and then diluted with 90ml of tetrahydrofuran. Next, dil. HCl solution (1.18mmol hydrochloride) prepared by mixing of 8.8ml conc. HCl (35wt.% hydrochloride) with 100ml D.I.-water was slowly added thereto at -78°C, followed by addition of more D.I.-water, so that total amount of water including the inherent water in the above added dil. HCl solution amounted to 393.61mmol(7.084g). Thereafter, the flask was slowly warmed to 70°C, and allowed to react for 16hrs. Then, the reaction mixture was transferred to a separatory funnel 90ml of diethylether was added thereto, and then rinsed with 5X100ml D.I.-water. Subsequently, 5g of anhydrous sodium sulfate was added thereto and stirred at room temperature for 10hrs to remove a trace of water, and then filtered out to provide a clear colorless solution. Any volatile materials were evaporated from this solution under reduced pressure of about 0.1torr to afford 5.3g of precursor A as white powder.

**Example 2-2**

**Precursor B: Copolymerization of monomer A and methyltrimethoxysilane**

To a flask were added 37.86mmol(5.158g) of methyltrimethoxysilane and 3.79mmol(3.162g) of monomer A, and then diluted with 100ml of tetrahydrofuran. Next, dil. HCl solution (0.0159mmol hydrochloride) prepared by dilution of 0.12ml conc. HCl (35wt.% hydrochloride) with 100ml D.I.-water was slowly added thereto at -78°C, followed by addition of more D.I.-water, so that total amount of water including the inherent water in the above added dil. HCl solution amounted to 529.67mmol(9.534g). Thereafter, the flask was slowly warmed to 70°C, and allowed to react for 16hrs. Then, the reaction mixture was transferred to a separatory funnel, 100ml diethylether was added thereto, and then rinsed with 5X100ml D.I.-water. Subsequently, 5g of anhydrous sodium sulfate was added thereto and stirred at room temperature for 10hrs to remove a trace of water, and then filtered out to provide a clear colorless solution. Any volatile materials were evaporated from this solution under reduced pressure of about 0.1torr to afford 5.5g of precursor B as white powder.

**Example 3: Analysis of the matrix precursors**

The siloxane-based resinous precursors thus prepared were analyzed for molecular weight (hereinafter, referred to as "MW") and molecular weight distribution (hereinafter, referred to as "MWD") by means of gel permeation chromatography (Waters Co.), and the Si-OH, Si-$OCH_3$ and Si-$CH_3$ contents (%) of their terminal groups were analyzed by means of NMR (Bruker Co.). The results are set forth in the following Table 1.

**Table 1**

| Precursor | MW | MWD | Si-OH (mol%) | Si-$OCH_3$ (mol%) | Si-$CH_3$ (mol%) |
|---|---|---|---|---|---|
| Precursor (A) | 60800 | 6.14 | 35.0 | 1.2 | 63.8 |
| Precursor (B) | 4020 | 2.77 | 39.8 | 0.5 | 59.7 |

$$\text{-OH}(\%) = \text{Area(Si-OH)} \div [\text{Area(Si-OH)} + \text{Area(Si-OCH}_3\text{)}/3 + \text{Area(Si-CH}_3\text{)}/3] \times 100$$

$$\cdot\text{Si-OCH}_3(\%) = \text{Area(Si-OCH}_3\text{)} \div [\text{Area(Si-OH)} + \text{Area(Si-OCH}_3\text{)}/3 + \text{Area(Si-CH}_3\text{)}/3] \times 100$$

$$\cdot\text{Si-CH}_3(\%) = \text{Area(Si-CH}_3\text{)} \div [\text{Area(Si-OH)} + \text{Area(Si-OCH}_3\text{)}/3 + \text{Area(Si-CH}_3\text{)}/3] \times 100$$

**Example 4: Preparing of pore-generating material**

**Example 4-1: Gemini detergent pore-generating material(a-1)**

In a flask were mixed 100ml acetonitrile and 10.0g of bis (chloromethyl) tetramethyldisiloxane (A), and then added 21.4g of tetradecyldimethylamine (n = 14, B). The mole ratio of A to B was set to 1:2.05. The obtained solution was heated at 82°C, for 24hr in the condition of reflex. The rotary evaporator removed the solvent, acetonitrile to provide solid- form product. To the solid product was added 2ml of chloroform and dissolved, and then added 500ml of ethyl acetate. Subsequently, the solution was retained at 0°C, for 12hr to recrystallization. Recrystallized material was filterd, and rinsed with 3X ethylacetate. Recrystallization, filtering, and rinsing were repeated two more times. The solvent was evaporated completely from the material obtained above by drying in a vacuum oven at 50°C, for 12hr to prepare $C_{14}H_{29}N(CH_3)_2ClCH_2Si(CH_3)_2OSi(CH_3)_2CH_2ClN(CH_3)_2C_{14}H_{29}$.

Example 4-2: Gemini detergent pore-generating material (a-2)

In a flask were mixed 200ml of ethanol and 7.24g of $BrCH_2CH_2CH_2OSi(CH_3)_2OSi(CH_3)_2OSi(CH_3)_2OCH_2CH_2CH_2Br$ (A), and then 9.15g of octadecyldimethylamine(B) were added thereto. The mole ratio of A to B was set to 1:2.05 in the reactants. The obtained solution was heated for 48hr in the condition of reflex. The solvent, ethanol was removed by the rotary evaporator to provide solid- form product. The solid component was added to 2ml chloroform and dissolved, and then added 500ml ethyl acetate. Subsequently, the solution was retained at 0°C, for 12hr for recrystallization. Recrystallized materials were filtered, and rinsed with 3X ethylacetate. Recrystallization, filtering, and rinsing were repeated two more times. The solvent was evaporated completely from the material obtained above by vacuum oven at 50°C, for 12hr to prepare $C_{18}H_{37}N(CH_3)_2BrCH_2CH_2CH_2OSi(CH_3)_2OSi(CH_3)_2OSi(CH_3)_2OCH_2CH_2CH_22rN(CH_3)_2C_{18}H_{37}$.

**Example 5: Determination of thickness and refractive index of the thin film comprising the substance having nano-pores**

The compositions for preparing a thin film were prepared by mixing the siloxane-based resinous matrix precursor obtained from the above Example 2 together with pore-generating material and propylene glycol methyl ether acetate (PGMEA) in accordance with the particular ratios as described in the following Table 2. These compositions were applied to spin-coating at 3000rpm onto p-type silicon wafers doped with boron. The substrates thus coated were then subjected to a series of soft baking on a hot plate for 1min at 150°C and another minute at 250°C, so that the organic solvent might be sufficiently removed. Then, the substrates were cured in a Linberg furnace at 420°C for 60min under vacuum condition. Thereafter, the thickness of each resulting low dielectric film and the refractive index were determined by using prism coupler. The results are set forth in the following Table 2.

**Table 2**

| Example No. | Precursor | Pore-generating material | Mat. (1) (wt.%) | Pore-generating(2) material (wt.%) | Thickness (A) | Refractive Index |
|---|---|---|---|---|---|---|
| Example 5-1 | Precur sor (A) | | 25.0 | _ | 8250 | 1.4353 |
| Example 5-2 | Precur sor (A) | | 25.0 | 20wt.% | 10200 | 1.3760 |
| Example 5-3 | Precur sor (A) | (a-2) | 25.0 | 20wt.% | 9800 | 2.3646 |
| Example 5-4 | Precur sor (A) | (a-1) +(b-2) | 25.0 | (a-1):10wt.% +(b-2):20wt.% | 10300 | 1.3360 |
| Example 5-5 | Precur sor (A) | (a-1) +(c) | 25.0 | (a-1):20 wt.% +(c):10 wt.% | 9500 | 1.3360 |
| Example 5-6 | Precur sor (A) | (a-1) +(c) | 25.0 | (a-1):10 wt.% +(c):20 wt.% | 9900 | 1.3296 |
| Example 5-7 | Precur sor (A) | (a-2) +(c) | 25.0 | (a-2):10 wt.% +(c):20 wt.% | 10050 | 1.3382 |
| Example 5-8 | Precur sor (B) | - | 30.0 | - | 9800 | 1.4147 |
| Example 5-9 | Precur sor (B) | (a-1) | 30.0 | 20 wt.% | 11030 | 1.3379 |
| Example 5-10 | Precur sor (B) | (a-1) | 30.0 | 30 wt.% | 11500 | 1.3011 |
| Example 5-11 | Precur sor (B) | (a-1) +(b-1) | 30.0 | (a-1):10 wt.% +(b-1):20wt.% | 11000 | 1.3087 |
| Example 5-12 | Precur sor (B) | (a-1) +(c) | 30.0 | (a-1):10 wt.% +(c):20 wt.% | 10700 | 1.3077 |
| Example 5-13 | Precur sor (B) | (a-1) +(c) | 30.0 | (a-1):10 wt.% +(c):20 wt.% | 11200 | 1.3144 |
| Example 5-14 | Precur sor (A) | (b-1) | 30.0 | 20 wt.% | 9500 | 1.3314 |
| Example 5-15 | Precur sor (A) | (b-1) +(c) | 30.0 | (b-1):10 wt.% +(c):20 wt.% | 9400 | 1.3297 |
| Example 5-16 | Precur sor (B) | (b-1) | 30.0 | 20 wt.% | 9600 | 1.3378 |
| Example | Precur | (b-1) | 30.0 | (b-1): 10wt.% | 11000 | 1.3110 |

(continued)

| Example No. | Precursor | Pore-generating material | Mat. (1) (wt.%) | Pore-generating(2) material (wt.%) | Thickness (A) | Refractive Index |
|---|---|---|---|---|---|---|
| 5-17 | sor (B) | +(c) | | +(c) :20wt.% | | |

Pore-generating material (b-1) : tetrahexylammonium bromide, purchased from Sigma Aldrich Co. and used without any purification.

(Wt.%) =[weight of matrix precursor (g)+weight of pore-generating material (g) / [weight of PGMEA (g)+weight of matrix precursor (g)+ weight of pore-generating material (g)] x 100

·Pore-generating material (2) (wt.%) = weight of pore-generating material (g) / [weight of pore-generating material (g)+weight of matrix precursor (g)] x 100

Pore-generating material(b-2) : didecyldimethylammonium bromide, purchased from Sigma Aldrich Co. and used without any purification.

Pore-generating material(c) : heptakis(2, 4, 6-tri-O-methyl)-β-cyclodextrin, purchased from Sigma Aldrich co. and used without any purification.

**Example 6: Preparing the thin film determiner of dielectric constant and determination of dielectric constant**

To determine the dielectric constant of the porous thin film, 3000Å thickness of thermally-oxidized silicon film were applied onto p-type silicon wafers doped with boron, then 100Å titanium, 2000Å aluminum are deposited by metal evaporator and then low dielectric films in composition of Table 3 were coated in the same manner as in Example 5. Thereafter, 1mm diameter of circular aluminum thin film was deposited at 2000Å thickness by the hard mask, which was designed to have 1mm electrode diameter, in order to be completed MIM(Metal- insulator-metal)-dielectric constant determiner capacitance of these thin films was measured using PRECISION LCR METER (HP4284A) with Probe station (Micromanipulator 6200 probe station) at 100Hz frequency. The thickness of the thin films was also measured using prism coupler. The dielectric constant was measured according to the following equation.

$$k = (C \times d) / (\varepsilon_0 \times A)$$

k : dielectric constant
C : capacitance
A : the contact area of electrode
$\varepsilon_0$ : dielectric constant of vacuum
d : the thickness of the low dielectric thin film

**Table 3**

| Example No. | Precursor | Pore-generating material | Mat. (1) (wt.%) | Pore-generating(2) material (wt.%) | Dielectric constant |
|---|---|---|---|---|---|
| Example 6-1 | Precursor (A) | - | 25.0 | _ | 2.715 |
| Example 6-2 | Precursor (A) | (a-1) | 25.0 | 20wt.% | 2.398 |
| Example 6-3 | Precursor (A) | (a-2) | 25.0 | 20wt.% | 2.369 |
| Example 6-4 | Precursor (A) | (a-1)+(b-2) | 25.0 | (a-1):10 wt.% +(b-2):20 wt.% | 2.226 |
| Example 6-5 | Precursor (A) | (a-1)+(c) | 25.0 | (a-1) :20 wt.% +(c) :10 wt.% | 2.201 |
| Example 6-6 | Precursor (A) | (a-1)+(c) | 25.0 | (a-1):10 wt.% +(c) :20 wt.% | 2.196 |
| Example 6-7 | Precursor (A) | (a-2)+(c) | 25.0 | (a-2):10 wt.% +(c) :20 wt.% | 2.237 |
| Example 6-8 | Precursor (B) | - | 30.0 | - | 3.653 |
| Example 6-9 | Precursor (B) | (a-1) | 30.0 | 20 wt.% | 2.353 |
| Example 6-10 | Precursor (B) | (a-1) | 30.0 | 30 wt.% | 2.202 |
| Example 6-11 | Precursor (B) | (a-1)+(b-1) | 30.0 | (a-1):10 wt.% +(b-1):20 wt.% | 2.184 |
| Example 6-12 | Precursor (B) | (a-1)+(c) | 30.0 | (a-1):10 wt.% +(c):20 wt.% | 2.102 |
| Example 6-13 | Precursor (B) | (a-1)+(c) | 30.0 | (a-1):20 wt.% +(c):10 wt.% | 2.178 |
| Example 6-14 | Precursor (A) | (b-1) | 30.0 | 20 wt.% | 2.314 |
| Example 6-15 | Precursor (A) | (b-1)+(c) | 30.0 | (b-1):10 wt.% +(c) :20 wt.% | 2.204 |
| Example 6-16 | Precursor (B) | (b-1) | 30.0 | 20 wt.% | 2.317 |
| Example 6-17 | Precursor | (b-1)+(c) | 30.0 | (b-1) :10wt.% | 2.191 |

(continued)

| Example No. | Precursor | Pore-generating material | Mat. (1) (wt.%) | Pore-generating(2) material (wt.%) | Dielectric constant |
|---|---|---|---|---|---|
| | (B) | | | +(c):20wt.% | |

(Wt.%) =[weight of matrix precursor (g)+weight of pore-generating material (g) / [weight of PGMEA (g)+weight of matrix precursor (g)+ weight of pore-generating material (g)] x 100

·Pore-generating material (2) (wt.%) = weight of pore-generating material (g) / [weight of pore-generating material (g)+weight of matrix precursor (g)] x 100

**Example 7:Measurement of Hydroscopicity of the thin film**

To measure hydroscopic degree of the porous thin film, the prepared determiner-thin film prepared in the above Example 5 were put in the D.I.water for 4days, taken out the film, and then water was removed from the thin film through blowing the nitrogen for 1min. Thereafter, the hydroscopicity was measured through the variation of capacitance which was gauged at 100kHz frequency using PRECISION LCR METER (HP4284A) with Probe station (Micromanipulator 6200 probe station).

Generally, if an adsorption happens, the capacitance adsorption test increases more than 10% afterwards the submersion under water compared with that of before. But in the present invention, it can be recognized that the adsorption does not happen from that the change of capacitance is very small.

**Table 4**

| Example No. | Precursor | Pore-generating materia 1 | Mat. (1) (wt.%) | Pore-generating(2) material (wt.%) | CP before submersion (pF) | CP after submersion (pF) |
|---|---|---|---|---|---|---|
| Example 7-1 | Precursor (A) | - | 25.0 | - | 22.14 | 22.72 |
| Example 7-2 | Precursor (A) | (a-1) | 25.0 | 20wt.% | 22.85 | 23.31 |
| Example 7-3 | Precursor (A) | (a-2) | 25.0 | 20wt.% | 27.82 | 27.48 |
| Example 7-4 | Precursor (A) | (a-1) +(b-2) | 25.0 | (a-1): 10wt.% +(b-2) : 20wt.% | 27.85 | 24.82 |
| Example 7-5 | Precursor (A) | (a-1) +(c) | 25.0 | (a-1) : 20wt.% +(c):10wt.% | 25.22 | 24.09 |
| Example 7-6 | Precursor (A) | (a-1) +(c) | 25.0 | (a-1):10 wt.% +(c):20 wt.% | 24.43 | 24.90 |
| Example 7-7 | Precursor (A) | (a-2) +(c) | 25.0 | (a-2):10 wt.% +(c) :20 wt.% | 9.68 | 9.65 |
| Example 7-8 | Precursor (B) | _ | 30.0 | _ | 6.49 | 6.55 |
| Example 7-9 | Precursor (B) | (a-1) | 30.0 | 20 wt.% | 5.47 | 5.55 |
| Example 7-10 | Precursor (B) | (a-1) | 30.0 | 30 wt.% | 6.04 | 6.12 |
| Example 7-11 | Precursor (B) | (a-1) +(b-1) | 30.0 | (a-1):10 wt.% +(b-1):20wt.% | 6.64 | 6.72 |
| Example 7-12 | Precursor (B) | (a-1) +(c) | 30.0 | (a-1):10 wt.% +(c) :20 wt.% | 8.33 | 8.15 |
| Example 7-13 | Precursor (B) | (a-1) +(c) | 30.0 | (a-1):20 wt.% +(c):10 wt.% | 8.81 | 8.41 |
| Example 7-14 | Precursor (A) | (b-1) | 25.0 | 20 wt.% | 22.35 | 22.55 |
| Example 7-15 | Precursor (A) | (b-1) +(c) | 25.0 | (b-1):10 wt.% +(c):20 wt.% | 24.04 | 24.11 |
| Example 7-16 | Precursor (B) | (b-1) | 30.0 | 20 wt.% | 5.44 | 5.43 |
| Example | Precursor | (b-1) | 30.0 | (b-1): 10wt.% | 7.22 | 7.21 |

(continued)

| Example No. | Precursor | Pore-generating materia 1 | Mat. (1) (wt.%) | Pore-generating(2) material (wt.%) | CP before submersion (pF) | CP after submersion (pF) |
|---|---|---|---|---|---|---|
| 7-17 | (B) | +(c) | | +(c) :20wt.% | | |

(Wt.%) =[weight of matrix precursor (g)+weight of pore-generating material (g) / [weight of PGMEA (g)+weight of matrix precursor (g)+ weight of pore-generating material (g)] x 100

·Pore-generating material (2) (wt.%) = weight of pore-generating material (g) / [weight of pore-generating material (g)+weight of matrix precursor (g)] x 100

**Example 8: Measurement of Mechanical Properties - Hardness and Modulus of the Thin-film**

Hardness and modulus of the thin-film prepared in the same process as in Example 5 were measured by Nanointender Πof MS Co. Hardness and modulus were measured when the intent depth was 10% of whole thin film thickness. Further, each sample of the thin films was indented to 6 point and the hardness and modulus of the thin film were determined from the mean value in order to ensure the confidence. And the thickness of the thin film was measured by the prism coupler. The results are described in Table 5.

**Table 5**

| Example No. | Precursor | Pore-generating material | Mat. (1) (wt.%) | Pore-generating(2) material (wt.%) | Thick ness (A) | Hard ness (Gpa ) | Modulous (Gpa) |
|---|---|---|---|---|---|---|---|
| Example 8-1 | Precursor (A) | - | 25.0 | - | 8400 | 9.84 | 0.86 |
| Exampl 8-2 | Precursor (A) | (a-1) | 25.0 | 10wt.% | 9100 | 6.74 | 0.76 |
| Example 8-3 | Precursor (A) | (a-1) | 25.0 | 20wt.% | 9900 | 5.41 | 0.61 |
| Example 8-4 | Precursor (A) | (a-1) | 25.0 | 30wt.% | 10300 | 3.41 | 0.47 |
| Example 8-5 | Precursor (A) | (a-2) | 25.0 | 30wt.% | 9800 | 3.42 | 0.48 |
| Example 8-6 | Precursor (A) | (a-1)+(c) | 25.0 | (a-1): 10wt.%+ (c):20wt.% | 10020 | 3.35 | 0.39 |
| Example 8-7 | Precursor (A) | (a-1)+(c) | 25.0 | (a-1): 20wt.%+ (c):10wt.% | 9700 | 3.34 | 0.38 |
| Example 8-8 | Precursor (A) | (a-1)+(b-1) | 25.0 | (a-1):20wt.%+ (b-1):10wt.% | 9800 | 3.43 | 0.48 |
| Example 8-9 | Precursor (A) | (a-2)+(b-1) | 25.0 | (a-1):20wt.%+ (b-1): 10wt.% | 11000 | 3.45 | 0.47 |
| Example 8-10 | Precursor (B) | - | 30.0 | - | 9600 | 9.68 | 0.87 |
| Example 8-11 | Precursor (B) | (a-1) | 30.0 | 20wt.% | 11030 | 4.71 | 0.57 |
| Example 8-12 | Precursor (B) | (a-1) | 30.0 | 30wt.% | 11500 | 3.31 | 0.41 |
| Example 8-13 | Precursor (B) | (a-1)+(b-1) | 30.0 | (a-1):10wt.% + (b-1): 20wt.% | 11000 | 3.40 | 0.45 |
| Example 8-14 | Precursor (B) | (a-1)+(c) | 30.0 | (a-1) :10wt.% +(c):20wt.% | 10700 | 3.19 | 0.40 |
| Example 8-15 | Precursor (B) | (a-1)+(c) | 30.0 | (a-1):20wt.% +(c):10wt.% | 11200 | 3.31 | 0.37 |
| Example 8-16 | Precursor (A) | (b-1) | 25.0 | 20wt% | 9500 | 5.51 | 0.62 |
| Example 8-17 | Precursor (A) | (b-1)+(c) | 30.0 | (b-1): 10wt% +(c):20wt% | 9400 | 3.47 | 0.41 |
| Example 8-18 | Precursor (B) | - | 30.0 | - | 9600 | 9.68 | 0.87 |

(continued)

| Example No. | Precursor | Pore-generating material | Mat. (1) (wt.%) | Pore-generating(2) material (wt.%) | Thick ness (A) | Hard ness (Gpa ) | Modulous (Gpa) |
|---|---|---|---|---|---|---|---|
| Example 8-19 | Precursor (B) | (b-1) | 30.0 | 10wt% | 10100 | 6.46 | 0.74 |
| Example 8-20 | Precursor (B) | (b-1) | 30.0 | 20wt% | 11000 | 4.92 | 0.59 |
| Example 8-21 | Precursor (B) | (b-1) | 30.0 | 30wt% | 11700 | 3.36 | 0.45 |
| Example 8-22 | Precursor (B) | (b-2) | 30.0 | 10wt% | 9500 | 5.88 | 0.80 |
| Example 8-23 | Precursor (B) | (b-2) | 30.0 | 20wt% | 9900 | 4.70 | 0.53 |
| Example 8-24 | Precursor (B) | (b-2) | 30.0 | 30wt% | 10100 | 3.20 | 0.42 |
| Example 8-25 | Precursor (B) | (b-1)+ (c) | 30.0 | (b-1): 10wt% +(c):20wt% | 10050 | 3.18 | 0.43 |
| Example 8-26 | Precursor (B) | (b-1)+ (c) | 30.0 | (b-1): 20wt% +(c):10wt% | 11000 | 3.44 | 0.42 |

·Mat.(1) (Wt.%) =[weight of matrix precursor (g)+weight of pore-generating material (g) / [weight of PGMEA (g)+weight of matrix precursor (g)+ weight of pore-generating material (g)] x 100

·Pore-generating material(2) (wt.%) = weight of pc generating material (g) / [weight of pore-generati material (g)+weight of matrix precursor (g)] x 100

There is provided materials having pores produced by the use of the composition of the present invention, and their use as heat resisting materials, electric insulators, absorbents, carriers for catalysts. In particular, these substances may be useful for insulating films between interconnect layers in semi-conductor devices, since their dielectric constant, k is as sufficiently low as 2.5 or less.

## Claims

1. A composition for preparing porous dielectric thin film, said composition comprising:

   (1) a pore generating material of gemini detergent represented by the formula (8), or a mixture thereof with a quaternary alkylammonium salt represented by the formula (9);
   (2) thermo-stable organic or inorganic matrix precursor; and
   (3) a solvent for dissolving both the said material and the matrix precursor:

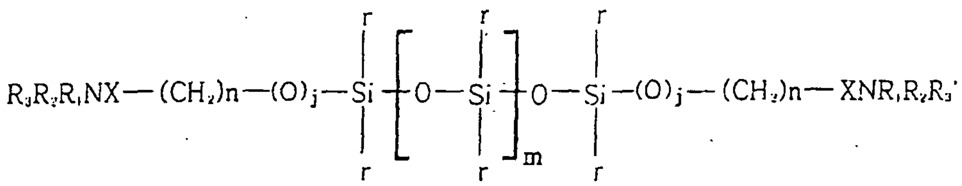

(8)

   wherein,
   $R_1$ and $R_2$ are independently methyl group or ethyl group;
   $R_3$ is $C_{5-40}$ alkyl group;
   X is a halogen atom;
   r is independently hydrogen atom, methyl group or $C_{1-10}$ alkoxy group;
   j is 0 or 1;
   n is an integer ranging from 1 to 12; and
   m is an integer ranging from 0 to 10, and

$$NL_1L_2L_3\,L_4X \qquad [9]$$

   wherein,
   N is nitrogen atom;
   X is a halogen atom; and
   $L_1$, $L_2$, $L_3$, and $L_4$ are independently $C_{1-30}$ alkyl group.

2. The composition according to claim 1, wherein the content of the pore-generating material is 0.1-95 wt.% of the solid components (the pore-generating material + the matrix precursor).

3. The composition according to claim 1 or 2, wherein the content of the solvent is 20.0-99.9 wt.% of the composition (the matrix precursor + the pore-generating material + the matrix precursor).

4. The composition according to any of claims 1 to 3, wherein the pore-generating material further comprises a cyclodextrin derivative represented by the formula (12).

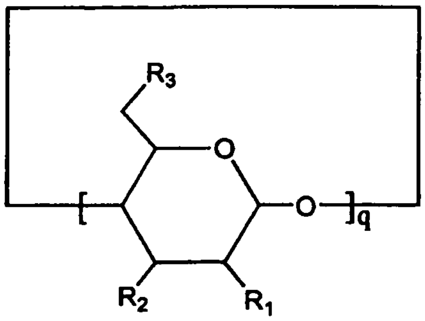

[12]

wherein,
q is an integer ranging from 6 to 12;
$R_1$, $R_2$ and $R_3$ are independently halogen atom, $C_{0-10}$ amino group or azido group, $C_{3-20}$ imidazole group or pyridino group, $C_{1-10}$ cyano group, $C_{2-10}$ carbonate group, $C_{1-10}$ carbamate group or functional group represented $-OR_4$, $R_4$ is hydrogen atom, $C_{2-30}$ acyl group, $C_{1-20}$ alkyl group, $C_{3-10}$ alkene group, $C_2$ alkyne group, $C_{7-20}$ tosyl group, $C_{1-10}$ mesyl group, $C_{0-10}$ phosphorous group, $C_{3-10}$ cycloalkyl group, $C_{6-30}$ aryl group, $C_{1-20}$ hydroxy alkyl group, carboxyl group, $C_{1-20}$ carboxy alkyl group, glucosyl group or maltosyl group, or silicon compounds represented by $Sir_1r_2r_3$, wherein $r_1$, $r_2$ and $r_3$ are independently $C_{1-5}$ alkyl group, $C_{1-5}$ alkoxy group, or $C_{6-20}$ aryl group.

**5.** The composition according to claim 4, wherein the cyclodextrin derivative is selected from α-, β- or γ-cyclodextrin derivatives represented by the formulae (13) to (15):

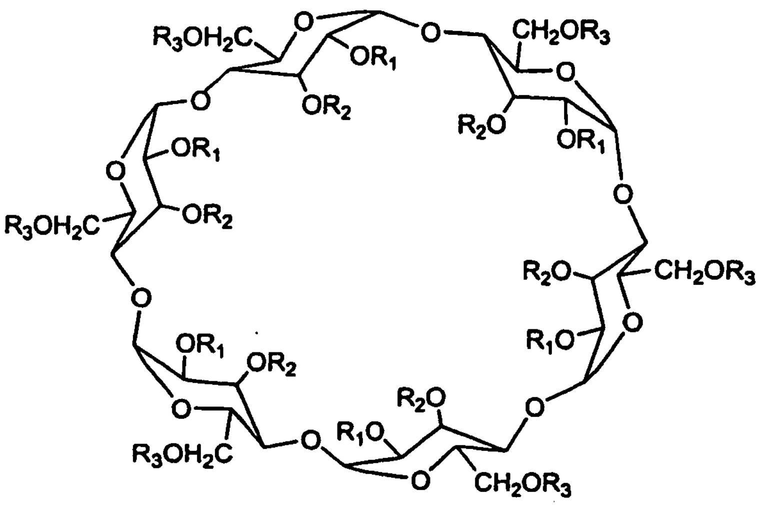

(13)

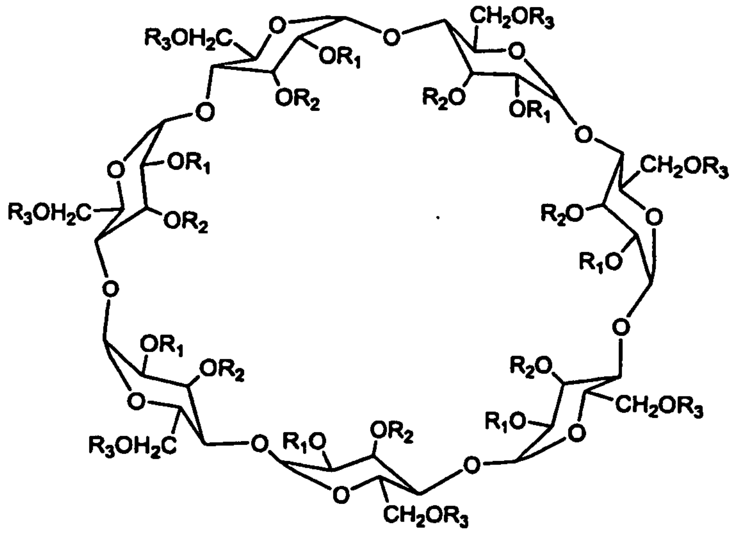

(14)

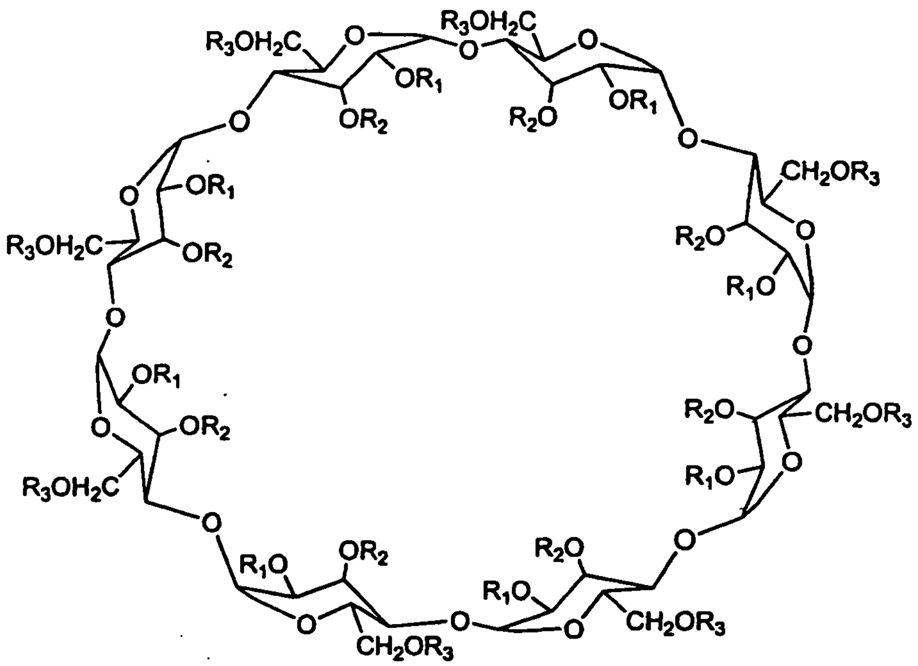

(15)

wherein,
$R_1$, $R_2$ and $R_3$ are independently halogen atom, $C_{0-10}$ amino group or azido group, $C_{3-20}$ imidazole group or pyridino group, $C_{1-10}$ cyano group, $C_{2-10}$ carbonate group, $C_{1-10}$ carbamate group or functional group represented $-OR_4$, $R_4$ is hydrogen atom, $C_{2-30}$ acyl group, $C_{1-20}$ alkyl group, $C_{3-10}$ alkene group, $C_2$ alkyne group, $C_{7-20}$ tosyl group, $C_{1-10}$ mesyl group, $C_{0-10}$ phosphorous group, $C_{3-10}$ cycloalkyl group, $C_{6-30}$ aryl group, $C_{1-20}$ hydroxy alkyl group, carboxyl group, $C_{1-20}$ carboxy alkyl group, glucosyl group or maltosyl group, or silicon compounds represented by $Sir_1r_2r_3$, wherein $r_1$, $r_2$ and $r_3$ are independently $C_{1-5}$ alkyl group, $C_{1-5}$ alkoxy group, or $C_{6-20}$ aryl group.

**6.** The composition according to claim 4 or 5, wherein the content of the cyclodextrin derivative is 5~95wt.% of the total pore-generating material.

**7.** The composition according to any of claims 1 to 6, wherein the quaternary alkylammonate is selected from tetramethylammonium bromide, tetraethylammonium bromide, tetrapropylammonium bromide, tetrabutylammonium bromide, tetrapentylammonium bromide, tetrahexylammonium bromide, tetraheptylammonium bromide, tetraoctylammonium bromide, tetrahexadecylammonium bromide, tetraoctadecylammonium bromide, diethyldimethylammonium bromide, dipropyldimethylammonium bromide, dibutyldimethylammonium bromide, dipentyldimethylammonium bromide, dihexyldimethylammonium bromide, diheptyldimethylammonium bromide, dioctyldimethylammonium bromide, didecyldimethylammonium bromide.

**8.** The composition according to any of claims 1 to 7, wherein the matrix precursor is silsesquioxane, alkoxysilane sol, or a siloxane-based polymer.

**9.** The composition according to claim 8, wherein the silsesquioxane is hydrogen silsesquioxane, alkyl silsesquioxane, aryl silsesquioxane, or a copolymer thereof.

**10.** The composition according to any of claims 1 to 7, wherein the matrix precursor is a siloxane-based resin which is prepared by hydrolysis and polycondensation of one or more monomer selected from compounds represented by the following formulae (1) to (4) in an organic solvent in the presence of a catalyst and water:

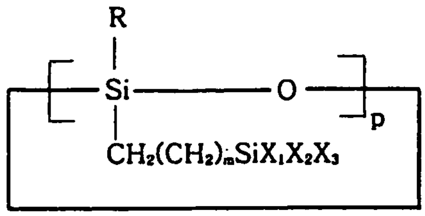

(1)

wherein,
R is hydrogen atom, $C_{1-3}$ alkyl group, $C_{3-10}$ cycloalkyl group, or $C_{6-15}$ aryl group;
$X_1$, $X_2$ and $X_3$ are independently $C_{1-3}$ alkyl group, $C_{1-10}$ alkoxy group, or halogen atom; at least one thereof is hydrolysable; and
p is an integer ranging from 3 to 8; m is an integer ranging from 0 to 10, and

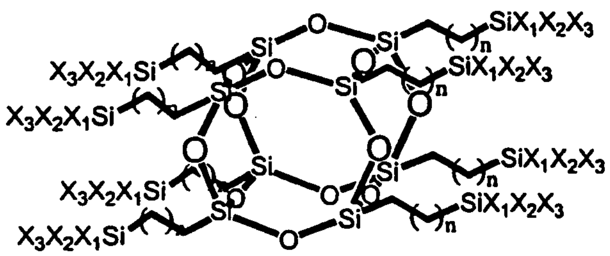

(2)

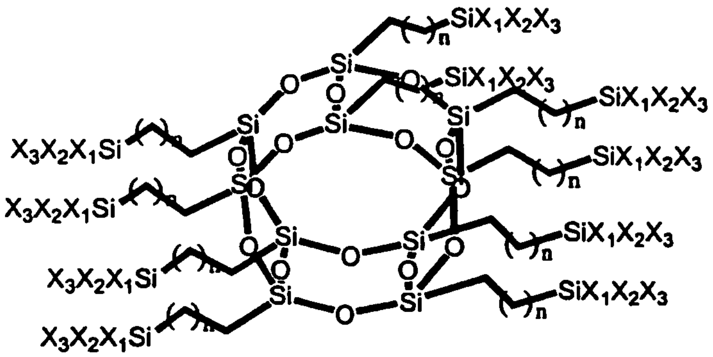

(3)

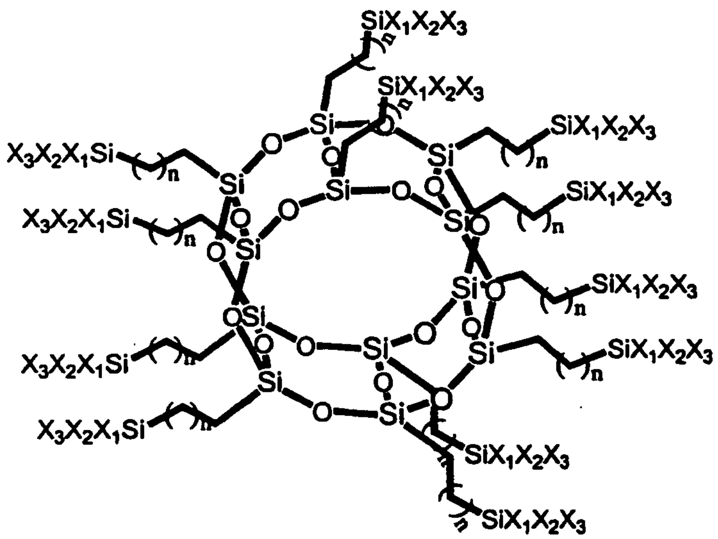

(4)

wherein,
R is hydrogen atom;
$X_1$, $X_2$ and $X_3$ are independently hydrogen atom, $C_{1-3}$ alkyl group, $C_{1-10}$ alkoxy group, or halogen atom; at least one thereof is hydrolysable and n is an integer ranging from 1 to 10.

**11.** The composition according to any of claims 1 to 7, wherein the matrix precursor is a siloxane-based resin which is prepared by hydrolysis and polycondensation of one or more monomers selected from compounds represented by the formulae (1) to (4)as defined in claim 10 together with one or more silane-based monomers selected from the group consisting of compounds represented by the following formulas (5) to (7) in an organic solvent in the presence of a catalyst and water:

$SiX_1X_2X_3X_4$ (5)

$RSiX_1X_2X_3$ (6)

$R_1R_2$ Si $X_1X_2$ (7)

wherein,
R is as defined in claim 10,
$R_1$ and $R_2$ are independently hydrogen atom, $C_{1-3}$ alkyl group, $C_{3-10}$ cycloalkyl group, or $C_{6-15}$ aryl group;
$X_1$, $X_2$, $X_3$ and $X_4$ are independently $C_{1-3}$ alkyl group, $C_{1-10}$ alkoxy group, or halogen atom.

**12.** The composition according to claim 10, wherein the content of Si-OH of the matrix precursor is more than 10 mol%.

**13.** The composition according to claim 11, wherein the content of Si-OH of the matrix precursor is more than 10 mol%.

**14.** The composition according to claim 11 or 13, wherein the molar ratio of siloxane monomers having cyclic or cage structure to the silane-based monomers is 0.99:0.01-0.01:0.99.

**15.** The composition according to any of claims 1 to 7, wherein the matrix precursor is polyimide, polybenzocyclobutene, polyarylene, or a mixture thereof.

**16.** The composition according to any of claims 1 to 15, wherein the solvent is aromatic hydrocarbon-based solvent, ketone-based solvent, ether-based solvent, acetate-based solvent, amide-based solvent, γ-butyrolactone, acohol-based solvent, silicon-based solvent, or a mixture thereof.

**17.** A method for forming interlayer insulating films between interconnect layers in semiconductor devices, said method comprising:

coating the composition according to any of claims 1 to 16 on a substrate;
evaporating the solvent therefrom; and
heating the coating film at 150~600°C under inert gas atmosphere or vacuum condition.

**18.** The method according to claim 17, wherein the coating is carried out by spin-coating at 1000~5000rpm.

**19.** A substance having nano-pores, said substance being prepared by using the composition according to claim 1.

**20.** A method for using the substance having nano-pores according to claim 19 as heat-resistant materials, electric insulators, absorbents, or carriers for catalysts.

## Patentansprüche

**1.** Zusammensetzung zur Herstellung eines porösen dielektrischen Dünnfilms, wobei die Zusammensetzung umfasst:

(1) ein Poren erzeugendes Material des in Formel (8) dargestellten Gemini-Tensids oder eine Mischung davon mit einem quarternären Alkylammoniumsalz dargestellt durch die Formel (9);
(2) thermostabile organische oder anorganische Matrixvorstufe; und
(3) ein Lösemittel zum Lösen sowohl des Materials und der Matrixvorstufe:

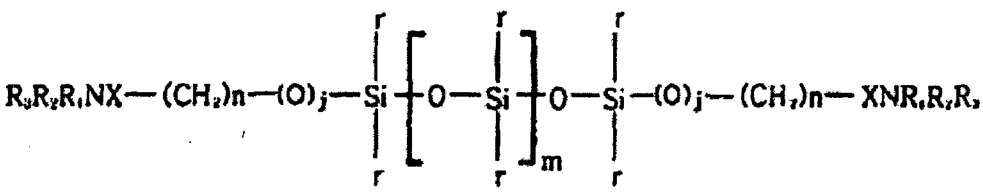

(8)

worin $R_1$ und $R_2$ unabhängig Methylgruppe oder Ethylgruppe sind;
$R_3$ $C_{5-40}$-Alkylgruppe ist;
X ein Halogenatom ist;
r unabhängig Wasserstoffatom, Methylgruppe oder $C_{1-10}$-Alkoxygruppe ist;
j 0 oder 1 ist;
n eine ganze Zahl im Bereich von 1 bis 12 ist; und
m eine ganze Zahl im Bereich von 0 bis 10 ist, und

$$NL_1L_2L_3L_4X \qquad (9)$$

worin

N ein Stickstoffatom ist;
X ein Halogenatom ist; und
$L_1$, $L_2$, $L_3$ und $L_4$ unabhängig $C_{1-30}$-Alkylgruppe sind.

**2.** Zusammensetzung nach Anspruch 1, worin der Gehalt an Poren erzeugendem Material 0,1 bis 95 Gew.-% der Feststoffkomponenten beträgt (das Poren erzeugende Material + die Matrixvorstufe).

**3.** Zusammensetzung nach Anspruch 1 oder 2, worin der Gehalt an Lösemittel 20,0 bis 99,9 Gew.-% der Zusammensetzung beträgt (Matrixvorstufe + Poren erzeugendes Material + Matrixvorstufe).

**4.** Zusammensetzung nach einem der Ansprüche 1 bis 3, worin das Poren erzeugende Material ferner ein Cyclodextrinderivat umfasst, das durch die Formel (12) dargestellt ist

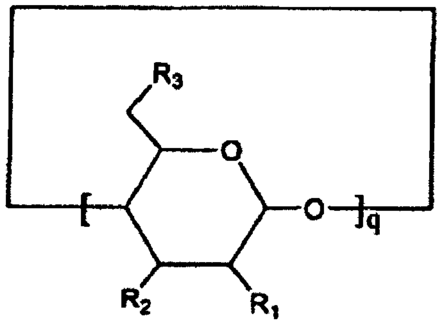

(12)

worin q eine ganze Zahl im Bereich von 6 bis 12 ist;
$R_1$, $R_2$ und $R_3$ unabhängig Wasserstoffatom, $C_{0-10}$-Aminogruppe oder Azidogruppe, $C_{3-20}$-Imidazolgruppe oder Pyridingruppe, $C_{1-10}$-Cyanogruppe, $C_{2-10}$-Carbonatgruppe, $C_{1-10}$-Carbamatgruppe oder funktionelle Gruppe dargestellt durch $-OR_4$ ist,
$R_4$ Wasserstoffatom ist, $C_{2-30}$-Acylgruppe, $C_{1-20}$-Alkylgruppe, $C_{3-10}$-Alkengruppe, $C_2$-Alkingruppe, $C_{7-20}$-Tosylgruppe, $C_{1-10}$-Mesylgruppe, $C_{0-10}$-Phosphorgruppe, $C_{3-10}$-Cycloalkylgruppe, $C_{6-30}$-Arylgruppe, $C_{1-20}$-Hydroxyalkylgruppe, Carboxylgruppe, $C_{1-20}$-Carboxyalkylgruppe, Glucosylgruppe oder Maltosylgruppe, oder Siliciumverbindungen dargestellt durch $Sir_1r_2r_3$, worin $r_1$, $r_2$ und $r_3$ unabhängig $C_{1-5}$-Alkylgruppe, $C_{1-5}$-Alkoxygruppe oder $C_{6-20}$-Arylgruppe sind.

**5.** Zusammensetzung nach Anspruch 4, worin das Cyclodextrinderivat ausgewählt ist aus α-, β- oder γ-Cyclodextrinderivaten dargestellt durch die Formeln (13) bis (15):

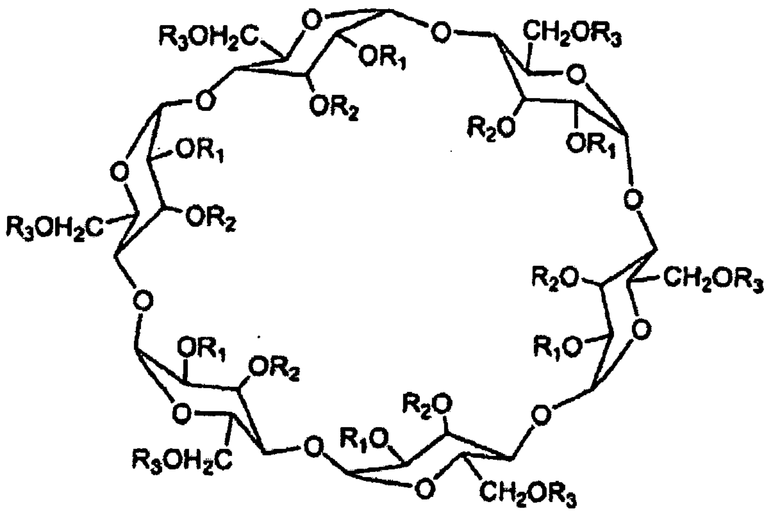

(13)

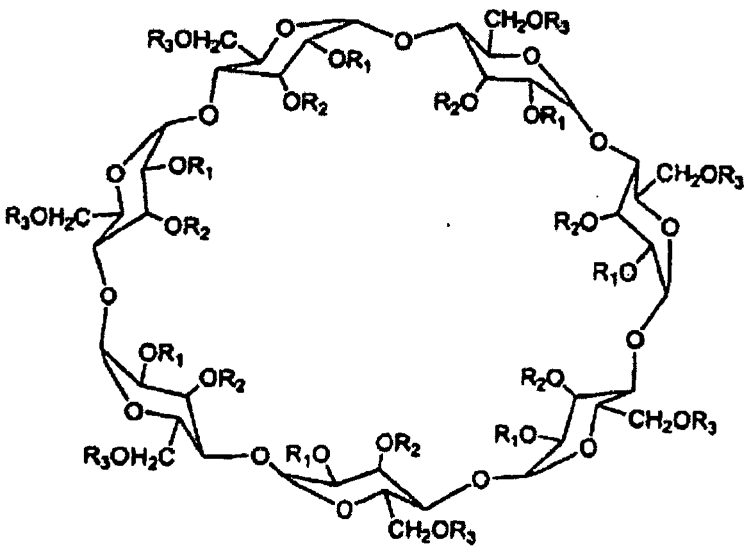

(14)

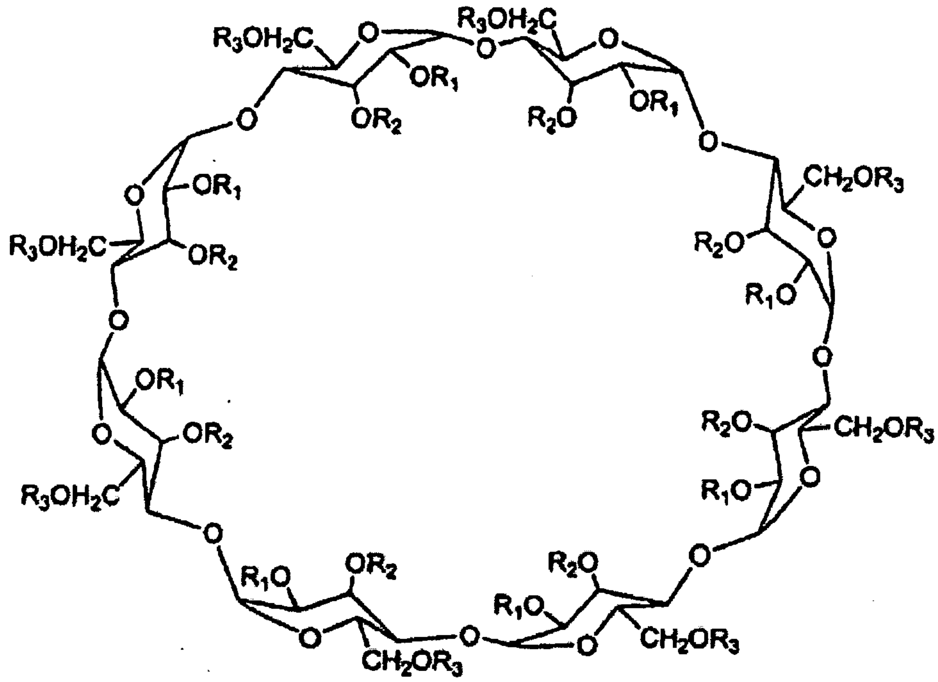

(15)

worin

$R_1$, $R_2$ und $R_3$ unabhängig Wasserstoffatom, $C_{0-10}$-Aminogruppe oder Azidogruppe, $C_{3-20}$-Imidazolgruppe oder Pyridingruppe, $C_{1-10}$-Cyanogruppe, $C_{2-10}$-Carbonatgruppe, $C_{1-10}$-Carbamatgruppe oder funktionelle Gruppe dargestellt durch $-OR_4$ sind,

$R_4$ Wasserstoffatom ist, $C_{2-30}$-Acylgruppe, $C_{1-20}$-Alkylgruppe, $C_{3-10}$-Alkengruppe, $C_2$-Alkingruppe, $C_{7-20}$-Tosylgruppe, $C_{1-10}$-Mesylgruppe, $C_{0-10}$-Phosphorgruppe, $C_{3-10}$-Cycloalkylgruppe, $C_{6-30}$-Arylgruppe, $C_{1-20}$-Hydroxyalkylgruppe, Carboxylgruppe, $C_{1-20}$-Carboxyalkylgruppe, Glucosylgruppe oder Maltosylgruppe, oder Siliciumverbindungen dargestellt durch $Sir_1r_2r_3$, worin $r_1$, $r_2$ und $r_3$ unabhängig $C_{1-5}$-Alkylgruppe, $C_{1-5}$-Alkoxygruppe oder $C_{6-20}$-Arylgruppe sind.

**6.** Zusammensetzung nach Anspruch 4 der 5, worin der Gehalt an Cyclodextrinderivat 5 bis 95 Gew.-% des gesamten Poren erzeugenden Materials ist.

**7.** Zusammensetzung nach einem der Ansprüche 1 bis 6, worin das quarternäre Alkylammonat ausgewählt ist aus Tetramethylammoniumbromid, Tetraethylammoniumbromid, Tetrapropylammoniumbromid, Tetrabutylammoniumbromid, Tetrapentylammoniumbromid, Tetrahexylammoniumbromid, Tetraheptylammoniumbromid, Tetraoctylammoniumbromid, Tetrahexadecylammoniumbromid, Tetraoctadecylammoniumbromid, Diethyldimethylammoniumbromid, Dipropyldimethylammoniumbromid, Dibutyldimethylammoniumbromid, Dipentyldimethylammoniumbromid, Dihexyldimethylammoniumbromid, Diheptyldimethylammoniumbromid, Dioctyldimethylammoniumbromid, Didecyldimethylammoniumbromid.

**8.** Zusammensetzung nach einem der Ansprüche 1 bis 7, worin die Matrixvorstufe Silsesquioxan, Alkoxysilansol oder ein Siloxanpolymer ist.

**9.** Zusammensetzung nach Anspruch 8, worin das Silsesquioxan Wasserstoffsilsesquioxan, Alkylsilsesquioxan, Arylsilsesquioxan oder ein Copolymer davon ist.

**10.** Zusammensetzung nach einem der Ansprüche 1 bis 7, worin die Matrixvorstufe ein Siloxanharz ist, das durch Hydrolyse und Polykondensation eines oder mehrerer Monomere ausgewählt aus Verbindungen, die durch die folgenden Formeln (1) bis (4) dargestellt sind, in einem organischen Lösemittel in Gegenwart eines Katalysators und Wasser hergestellt ist:

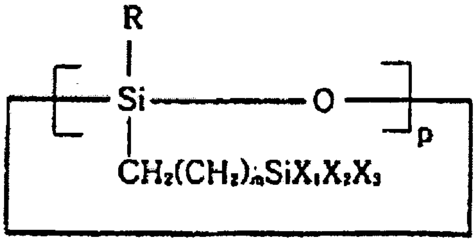

(1)

worin

R Wasserstoffatom, $C_{1-3}$-Alkylgruppe, $C_{3-10}$-Cycloalkylgruppe oder $C_{6-15}$-Arylgruppe ist;

$x_1$, $X_2$ und $X_3$ unabhängig $C_{1-3}$-Alkylgruppe, $C_{1-10}$-Alkoxygruppe oder Halogenatom sind, wobei mindestens eines davon hydrolysierbar ist; und

p eine ganze Zahl im Bereich von 3 bis 8 ist, m eine ganze Zahl im Bereich von 0 bis 10 ist, und

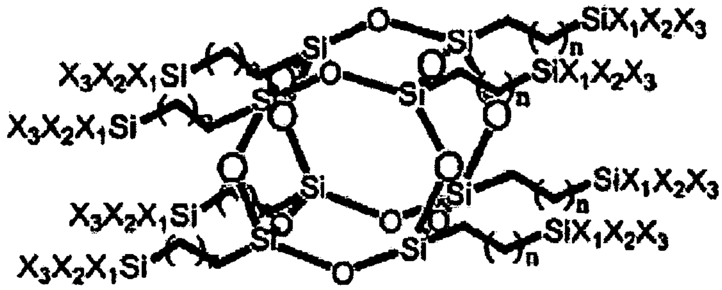

(2)

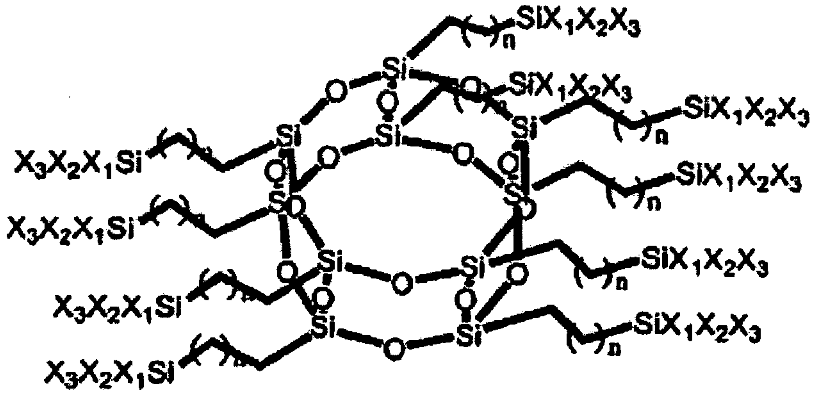

(3)

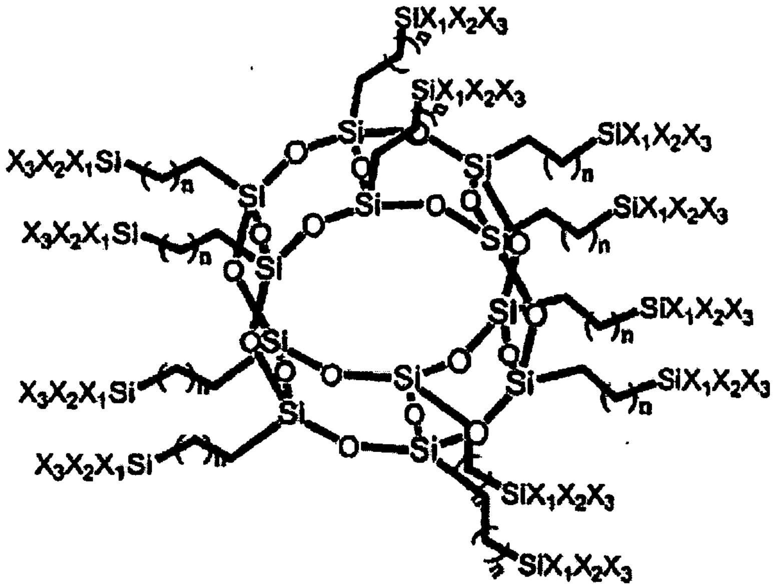

(4)

worin
R Wasserstoffatom ist;
$X_1$, $X_2$ und $X_3$ unabhängig Wasserstoffatom, $C_{1-3}$-Alkylgruppe, $C_{1-10}$-Alkoxygruppe oder Halogenatom sind, wobei mindestens eines davon hydrolysierbar ist und n eine ganze Zahl im Bereich von 1 bis 10 ist.

**11.** Zusammensetzung nach einem der Ansprüche 1 bis 7, worin die Matrixvorstufe ein Siloxanharz ist, das durch Hydrolyse und Polykondensation eines oder mehrerer Monomere ausgewählt aus Verbindungen, die durch die folgenden Formeln (1) bis (4) dargestellt sind, wie in Anspruch 10 definiert zusammen mit einem oder mehreren Silanmonomeren ausgewählt aus der Gruppe bestehend aus Verbindungen, die durch die folgenden Formeln (5) bis (7) dargestellt sind, in einem organischen Lösemittel in Gegenwart eines Katalysators und Wasser hergestellt ist:

$SiX_1X_2X_3X_4$ (5)

$RSiX_1X_2X_3$ (6)

$R_1R_2$ Si $X_1X_2$ (7)

worin R wie in Anspruch 10 definiert ist,
$R_1$ und $R_2$ unabhängig Wasserstoffatom, $C_{1-3}$-Alkylgruppe, $C_{3-10}$-Cycloalkylgruppe oder $C_{6-15}$-Arylgruppe sind;
$X_1$, $X_2$, $X_3$ und $X_4$ unabhängig $C_{1-3}$-Alkylgruppe, $C_{1-10}$-Alkoxygruppe oder Halogenatom sind.

**12.** Zusammensetzung nach Anspruch 10, worin der Gehalt an Si-OH der Matrixvorstufe mehr als 10 mol-% beträgt.

**13.** Zusammensetzung nach Anspruch 11, worin der Gehalt an Si-OH der Matrixvorstufe mehr als 10 mol-% beträgt.

**14.** Zusammensetzung nach Anspruch 11 oder 13, worin das Molverhältnis von Siloxanmonomeren mit cyclischer Struktur oder Käfigstruktur zu Silanmonomeren 0,99:0,01 bis 0,01:0,99 beträgt.

**15.** Zusammensetzung nach einem der Ansprüche 1 bis 7, worin die Matrixvorstufe Polyimid, Polybenzocyclobuten, Polyarylen oder eine Mischung davon ist.

**16.** Zusammensetzung nach einem der Ansprüche 1 bis 15, worin das Lösemittel ein Lösemittel auf Basis aromatischer Kohlenwasserstoffe, Lösemittel auf Ketonbasis, Lösemittel auf Etherbasis, Lösemittel auf Acetatbasis, Lösemittel auf Amidbasis, γ-Butyrolacton, Lösemittel auf Alkoholbasis, Lösemittel auf Siliciumbasis oder eine Mischung davon ist.

**17.** Verfahren zum Ausbilden von Zwischenschichtisolierfilmen zwischen Verbindungsschichten in Halbleiteranordnungen, wobei das Verfahren umfasst:

Aufschichten der Zusammensetzung nach einem der Ansprüche 1 bis 16 auf ein Substrat;
Verdampfen des Lösemittels daraus; und
Erwärmen des Beschichtungsfilms bei 150 bis 160 °C unter Inertgasatmosphäre oder Vakuumbedingungen.

**18.** Verfahren nach Anspruch 17, worin das Beschichten durch Spinbeschichten bei 1000 bis 5000 Upm vorgenommen wird.

**19.** Substanz mit Nanoporen, wobei die Substanz unter Verwendung der Zusammensetzung nach Anspruch 1 hergestellt ist.

**20.** Verfahren zur Anwendung der Substanz mit Nanoporen nach Anspruch 19 als wärmebeständiges Material, elektrischer Isolator, Absorptionsmittel oder Träger für Katalysatoren.

## Revendications

**1.** Composition pour la préparation de film mince poreux diélectrique, ladite composition comprenant :

(1) une matière porogène de détergent gemini représenté par la formule (8), ou un mélange de celui-ci avec un sel d'alkylammonium quaternaire représenté par la formule (9) ;
(2) un précurseur de matrice thermo-stable organique ou inorganique ; et
(3) un solvant pour dissoudre à la fois ladite matière et le précurseur de matrice :

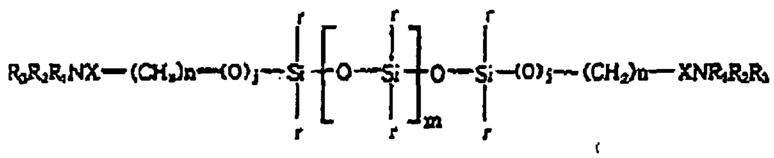

(8)

dans laquelle,
$R_1$ et $R_2$ représentent chacun, indépendamment l'un de l'autre, un groupe méthyle ou un groupe éthyle ;
$R_3$ représente un groupe alkyle en $C_5$ à $C_{40}$ ;
X représente un atome d'halogène ;
r représente indépendamment un atome d'hydrogène, un groupe méthyle ou un groupe alcoxyle en $C_1$ à $C_{10}$ ;
j vaut 0 ou 1 ;
n représente un nombre entier valant de 1 à 12 ; et
m représente un nombre entier valant de 0 à 10, et

$$NL_1L_2L_3\,L_4X \qquad [9]$$

où,
N représente un atome d'azote ;
X représente un atome d'halogène ; et
$L_1$, $L_2$, $L_3$ et $L_4$ représentent chacun, indépendamment les uns des autres, un groupe alkyle $C_1$ à $C_{30}$.

**2.** Composition selon la revendication 1, dans laquelle la teneur en matière porogène est de 0,1% à 95% en poids des composants solides (précurseur de matrice + matière porogène).

**3.** Composition selon la revendication 1 ou 2, dans laquelle la teneur du solvant est de 20,0% à 99,9% en poids de la composition (précurseur de matrice + matière porogène + précurseur de matrice).

**4.** Composition selon l'une quelconque des revendications 1 à 3, dans laquelle la matière porogène comprend en outre un dérivé de cycladextrine représenté par la formule (12) :

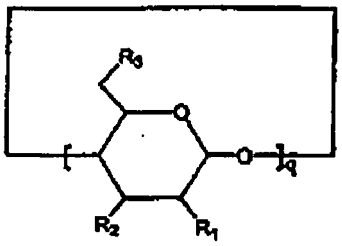

[12]

dans laquelle,
q représente un nombre entier valant de 6 à 12,
$R_1$, $R_2$ et $R_3$ représentent chacun, indépendamment l'un de l'autre, un atome d'halogène, un groupe amino ou azido en $C_0$ à $C_{10}$, un groupe imidazole en $C_3$ à $C_{20}$ ou un groupe pyridino, un groupe cyano en $C_1$ à $C_{10}$, un groupe carbonate en $C_2$ à $C_{10}$, un groupe carbamate en $C_1$ à $C_{10}$ ou un groupe fonctionnel représenté par $-OR_4$,
$R_4$ représente un atome d'hydrogène, un groupe acyle en $C_2$ à $C_{30}$, un groupe alkyle en $C_1$ à $C_{20}$, un groupe alcène en $C_3$ à $C_{10}$, un groupe alcyne en $C_2$, un groupe tosyle en $C_7$ à $C_{20}$, un groupe mésyle en $C_1$ à $C_{10}$, un groupe phosphoreux en $C_0$ à $C_{10}$, un groupe cycloalkyle en $C_3$ à $C_{10}$, un groupe aryle en $C_6$ à $C_{30}$, un groupe hydroxyalkyle en $C_1$ à $C_{20}$, un groupe carboxyle, un groupe carboxyalkyle en $C_1$ à $C_{20}$, un groupe glucosyle ou un groupe maltosyle, ou des composés de silicium représentés par $Sir_1r_2r_3$, où $r_1$, $r_2$ et $r_3$ représentent chacun, indépendamment l'un de l'autre un groupe alkyle en $C_1$ à $C_5$, un groupe alcoxyle en $C_1$ à $C_5$ ou un groupe aryle en $C_6$ à $C_{20}$.

**5.** Composition selon la revendication 4, dans lequel le dérivé de cyclodextrine est choisi parmi les dérivés d'α-, β- ou γ-cyclodextrine représentés par les formules (13) à (15) :

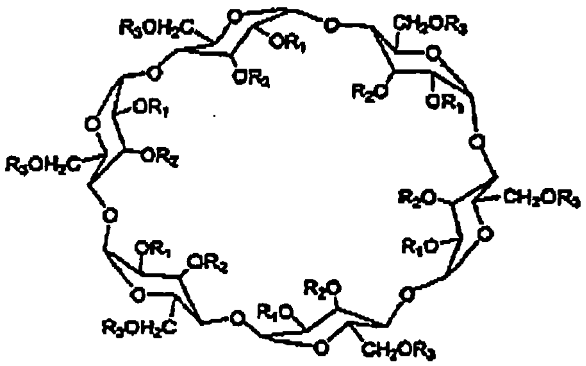

(13)

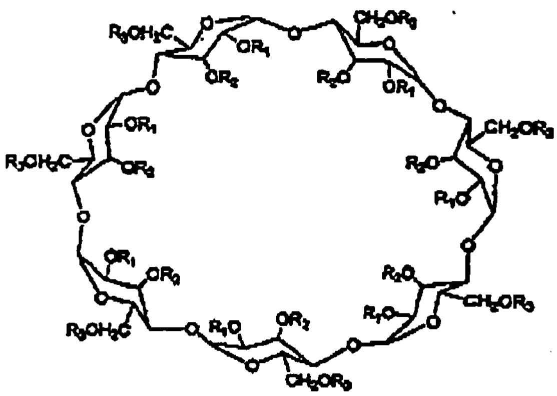

(14)

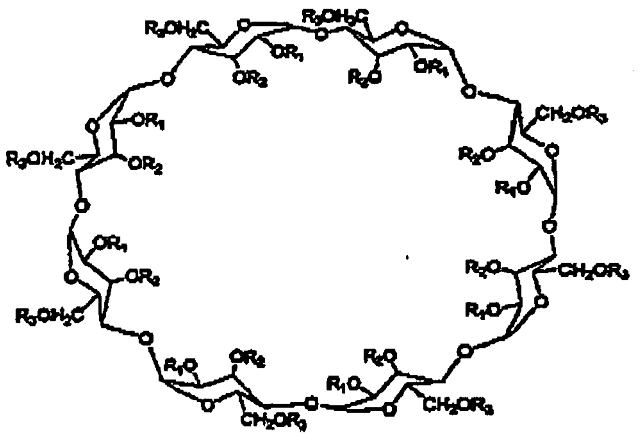

(15).

dans lesquelles,

$R_1$, $R_2$ et $R_3$ représentent chacun, indépendamment les uns des autres, un atome d'halogène, un groupe amino ou azido en $C_0$ à $C_{10}$, un groupe imidazole en $C_3$ à $C_{20}$ ou un groupe pyridino, un groupe cyano en $C_1$ à $C_{10}$, un groupe carbonate en $C_2$ à $C_{10}$, un groupe carbamate en $C_1$ à $C_{10}$ ou un groupe fonctionnel représenté par $-OR_4$, $R_4$ représente un atome d'hydrogène, un groupe acyle en $C_2$ à $C_{30}$, un groupe alkyle en $C_1$ à $C_{20}$, un groupe alcène en $C_3$ à $C_{10}$, un groupe alcyne en $C_2$, un groupe tosyle en $C_7$ à $C_{20}$, un groupe mésyle en $C_1$ à $C_{10}$, un groupe phosphoreux en $C_0$ à $C_{10}$, un groupe cycloalkyle en $C_3$ à $C_{10}$, un groupe aryle en $C_6$ à $C_{30}$, un groupe hydroxyalkyle en $C_1$ à $C_{20}$, un groupe carboxyle, un groupe carboxyalkyle en $C_1$ à $C_{20}$, un groupe glucosyle ou un groupe maltosyle, ou des composés de silicium représentés par $Sir_1r_2r_3$, où $r_1$, $r_2$ et $r_3$ représentent chacun, indépendamment l'un de l'autre, un groupe alkyle en $C_1$ à $C_5$, un groupe alcoxyle en $C_1$ à $C_5$ ou un groupe aryle en $C_6$ à $C_{20}$.

**6.** Composition selon la revendication 4 ou 5, dans laquelle la teneur en dérivé de cyclodextrine est de 5% à 95% en poids du total de la matière porogène.

**7.** Composition selon l'une quelconque des revendications 1 à 6, dans laquelle l'alkylammonium quaternaire est choisi parmi le bromure de tétraméthylammonium, le bromure de tétraéthylammonium, le bromure de tétrapropylammonium, le bromure de tétrabutylammonium, le bromure de tétrapentylammonium, le bromure de tétrahexylammonium, le bromure de tétraheptylammonium, le bromure de tétraoctylammonium, le bromure de tétrahexadécylammonium, le bromure de tétraoctadécylammonium, le bromure de diéthyldiméthylammonium, le bromure de dipropyldiméthylammonium, le bromure de dibutyldimethylammonium, le bromure de dipentyldiméthylammonium, le bromure de dihexyldiméthylammonium, le bromure de diheptyldiméthlammonium, le bromure de dioctyldiméthylammonium et le bromure de didécyldiméthylammonium.

**8.** composition selon l'une quelconque des revendications 1 à 7, dans laquelle le précurseur de matrice est le silsesquioxane, le sol d'alcoxysilane ou un polymère à base de siloxane.

**9.** Composition selon la revendication 8, dans laquelle le silsesquioxane est l'hydrogénosilsesquioxane, l'alkylsilsesquioxane, l'arylsilsesquioxane ou un copolymère de ceux-ci.

**10.** Composition selon l'une quelconque des revendications 1 à 7, dans laquelle le précurseur de matrice est une résine à base de siloxane qui est préparé par hydrolyse et polycondensation d'un ou plusieurs monomères choisis parmi les composés représentés par les formules suivantes (1) à (4) dans un solvant organique en présence d'un catalyseur et d'eau :

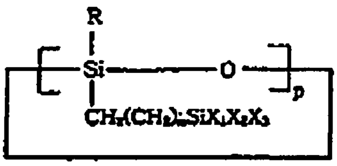

(1)

où,

R représente un atome d'hydrogène, un groupe alkyle en $C_1$ à $C_3$, un groupe cycloalkyle en $C_3$ à $C_{10}$ ou un groupe aryle en $C_6$ à $C_{15}$ ;

$X_1$, $X_2$ et $X_3$ représentent chacun, indépendamment les uns des autres, un groupe alkyle en $C_1$ à $C_3$, un groupe alcoxyle en $C_1$ à $C_{10}$ ou un atome d'halogène ; au moins l'un d'eux est hydrolysable ; et

p représente un nombre entier valant de 3 à 8 ; m représente un nombre entier valant de 0 à 10, et

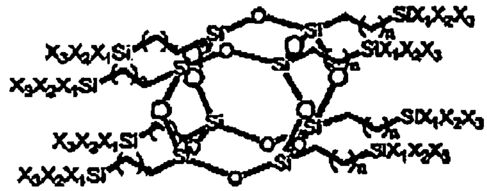

(2)

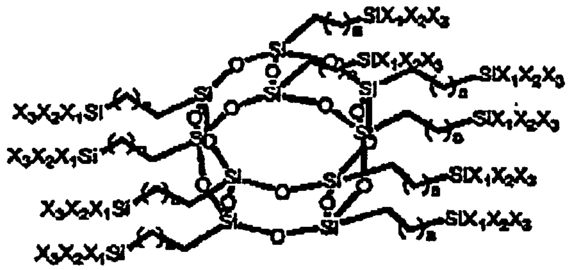

(3)

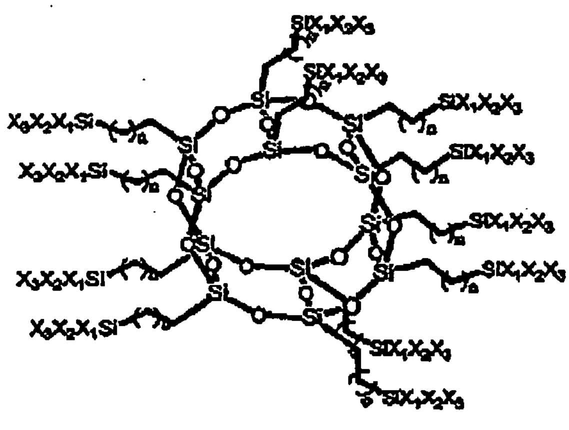

(4)

où,

R représente un atome d'hydrogène ;

$X_1$, $X_2$ et $X_3$ représentent chacun, indépendamment les uns des autres, un atome d'hydrogène, un groupe alkyle en $C_1$ à $C_3$, un groupe alcoxyle en $C_1$ à $C_{10}$ ou un atome d'halogène ; au moins l'un d'eux est hydrolysable et n représente un nombre entier valant de 1 à 10.

**11.** Composition selon l'une quelconque des revendications 1 à 7, dans laquelle le précurseur de matrice est une résine à base de siloxane qui est préparée par hydrolyse et polycondensation d'un ou plusieurs monomères choisis parmi les composés représentés par les formules (1) à (4) tel que défini dans la revendication 10 conjointement avec un ou plusieurs monomères à base de silane choisi dans le groupe constitué par les composés représentés par les formules suivantes (5) à (7) dans un solvant organique en présence d'un catalyseur et d'eau :

$$SiX_1X_2X_3X_4 \quad (5)$$

$$RSiX_1X_2X_3 \quad (6)$$

$$R_1R_2SiX_1X_2 \quad (7)$$

dans lesquelles,
R est tel que défini dans la revendication 10,
$R_1$ et $R_2$ représentent chacun, indépendamment l'un de l'autre, un atome d'hydrogène, un groupe alkyle en $C_1$ à $C_3$, un groupe cycloalkyle en $C_3$ à $C_{10}$ ou un groupe aryle en $C_6$ à $C_{15}$ ;
$X_1$, $X_2$, $X_3$ et $X_4$ représentent chacun, indépendamment les uns des autres, un groupe alkyle en $C_1$ à $C_3$, un groupe alcoxyle en $C_1$ à $C_{10}$ ou un atome d'halogène.

**12.** Composition selon la revendication 10, dans laquelle la teneur en Si-OH du précurseur de matrice est supérieure à 10 % en moles.

**13.** Composition selon la revendication 11, dans laquelle la teneur en Si-OH du précurseur de matrice est supérieure à 10 % en moles.

**14.** Composition selon la revendication 11 ou 13, dans laquelle le rapport molaire des monomères de siloxane ayant une structure cyclique ou de type cage aux monomères à base de silane est de 0,99:0,01 à 0,01:0,99.

**15.** Composition selon l'une quelconque des revendications 1 à 7, dans laquelle le précurseur de matrice est le polyimide, le polybenzocyclobutène, le polyarylène, ou un mélange de ceux-ci.

**16.** Composition selon l'une quelconque des revendications 1 à 15, dans laquelle le solvant est un solvant aromatique hydrocarboné, un solvant à base de cétone, un solvant à base d'éther, un solvant à base d'acétate, un solvant à base d'amide, la γ-butyrolactone, un solvant à base d'alcool, un solvant à base de silicium ou un mélange de ceux-ci.

**17.** Procédé de formation de films isolants de couche intermédiaire entre des couches d'interconnexion dans des dispositifs semiconducteurs, ledit procédé comprenant les étapes consistant à :

- déposer la composition selon l'une quelconque des revendications 1 à 16 sur un substrat ;
- éliminer le solvant de celle-ci par évaporation ; et
- chauffer le film de revêtement à une température de 150°C à 600°C sous un gaz inerte ou sous vide.

**18.** Procédé selon la revendication 17, dans lequel on réalise le revêtement par application centrifuge de 1 000 à 5 000 tr/min.

**19.** Substance ayant des nanopores, ladite substance étant préparée en utilisant la composition selon la revendication 1.

**20.** Procédé d'utilisation de la substance ayant des nanopores selon la revendication 19 en tant que matières résistant à la chaleur, isolante électriques, agents absorbants ou supports pour catalyseurs.